# EUROPÄISCHE PATENTSCHRIFT

(11) **EP 4 395 009 B1**
(45) Veröffentlichungstag und Bekanntmachung des Hinweises auf die Patenterteilung: **17.09.2025**
(21) Anmeldenummer: 23218392.1
(22) Anmeldetag: 20.12.2023
(51) Int. Cl.: H01M 10/617, H01M 10/6556, H01M 10/6557

(54) **GEGENSTROMTEMPERIERUNGSVORRICHTUNG, BATTERIEGEHÄUSE ZUR VERWENDUNG EINER TEMPERIERUNGSVORRICHTUNG**
COUNTER-CURRENT TEMPERING DEVICE, BATTERY HOUSING FOR USING A TEMPERING DEVICE
DISPOSITIF DE RÉGULATION DE TEMPÉRATURE À CONTRE-COURANT, BOÎTIER DE BATTERIE POUR UTILISER UN DISPOSITIF DE RÉGULATION DE TEMPÉRATURE

(30) Priorität: 23.12.2022 DE 102022134765
(43) Veröffentlichungstag der Anmeldung: 03.07.2024
(73) Patentinhaber: POLYTEC PLASTICS Germany GmbH & Co. KG, 49393 Lohne (DE)
(72) Erfinder: VAN GILST, Walter, 49393 Lohne (DE); HUCKLE, Jens, 76676 Graben-Neudorf (DE); BURKERT, Tobias, 49393 Lohne (DE); BUCK, Michael, 49401 Damme (DE); SOARES, Jorge, 49393 Lohne (DE); LESON, Christoph, 49393 Lohne (DE); BERDING, Christian, 49393 Lohne (DE)
(74) Vertreter: dompatent von Kreisler Selting Werner - Partnerschaft von Patent- und Rechtsanwälten mbB

(56) Entgegenhaltungen:
- WO-A1-2022/124251
- CN-A- 112 054 141
- CN-U- 217 158 331
- DE-U1- 202021 102 441
- FR-A1- 3 064 117
- JP-A- 2022 129 697

## Beschreibung

Die vorliegende Erfindung betrifft eine Gegenstromtemperierungsvorrichtung zur Temperierung mindestens eines Objektes, ein Batteriegehäuse umfassend eine Gegenstromtemperierungsvorrichtung sowie die Verwendung einer Gegenstromtemperierungsvorrichtung.

Für die Lebensdauer und Leistungsabgabe sowie für die Sicherheit von Akkumulatoren bzw. wiederaufladbaren Batterien ist die Temperatur der Akkumulatoren während der Leistungsaufnahme und -abgabe von essenzieller Bedeutung. Aus dem Stand der Technik sind bereits Vorrichtungen und Verfahren zur aktiven Temperierung von Akkumulatoren bzw. Batteriezellen bekannt geworden. Die bekannten Konzepte lassen sich in grundlegend zwei unterschiedliche Bereiche aufteilen, nämlich die konvektive Temperierung und die konduktive Temperierung der Batteriezellen.

Bei der konduktiven Kühlung wird mindestens ein Temperierkanal ausgebildet, welcher mit einem Temperiermedium durchströmt wird. Der mindestens eine Temperierkanal liegt dabei wärmeleitend an dem mindestens einem zu temperierenden Objekt, wie beispielsweise einem Akkumulator, an. Durch die Wahl der Temperatur des Temperiermediums und der Durchströmungsgeschwindigkeit des Mediums durch den mindestens einen Temperierkanal kann das zu temperierende Objekt auf eine gewünschte Temperatur gebracht werden. Es kann folglich eine aktive Kühlung oder Erhitzung vorgesehen werden.

Im Stand der Technik werden im Bereich der Batterietechnik beispielsweise im Elektromobilitätsbereich eine Vielzahl von Batterieeinzelzellen zu einer großen Batteriezellenanordnung beispielsweise in einem Batteriegehäuse verbunden bzw. verschaltet. In diesen Batteriegehäusen muss zur Realisierung einer aktiven und möglichst gleichmäßigen Temperierung der Vielzahl der Batteriezellen ebenso eine Mehrzahl von Temperierkanälen ausgebildet werden. Die Einzeltemperierkanäle verlaufen dabei zwischen, auf oder unter den Reihen der Einzelbatteriezellen. Nachteilig an den Vorrichtungen aus dem Stand der Technik ist, dass sich das Temperiermittel bei der Durchströmung der Temperierkanäle zunehmend an die Temperatur der zu temperierenden Objekte angleicht, derart, dass der Temperaturunterschied zwischen dem Temperiermittel und dem zu temperierenden Objekt geringer ist und damit ebenfalls die Wärmeübertragung abnimmt. Durch die Angleichung der Temperatur des Temperiermediums an die zu temperierenden Objekte entlang des Strömungsverlaufes des Temperierkanals ist es erforderlich, das Temperiermedium mit einer hohen Temperaturdifferenz und/oder einem hohen Volumenstrom zu den zu temperierenden Objekten in die Temperierkanäle zuzuführen, um noch eine geeignete Temperierung der zu temperierenden Objekte im Bereich des Endes des Temperierkanals zu erzielen.

Aus dem Stand der Technik sind einige Systeme zur Kühlung von Batterien bekannt. Die CN 217 158 331 U offenbart ein thermisches Managementsystem für einen zylindrischen Batteriestapel. FR 3 064 117 A1 betrifft eine Vorrichtung zur thermischen Regulierung von Speicherzellen für elektrische Energie, die mindestens zwei miteinander verbundene Wärmetauscher umfasst. Aus CN 112 054 141 A ist ein Gegenstrom-Flüssigkeitskühlungs-Batteriemanagement- und Feuerlöschsystem für eine Lithium-Ionen-Batterie bekannt. JP 2022 129697 A offenbart eine Batterievorrichtung zur Unterdrückung von Schwankungen im Grad der Verschlechterung einer Vielzahl von Batteriezellen. Eine Temperiervorrichtung für einzelne, zu einem Modul zusammengesetzte Batteriezellen ist aus DE 20 2021 102441 U1 bekannt. WO 2022/124251 A1 offenbart eine Batteriekühlvorrichtung zur gleichmäßigen Kühlung einer Batterie.

Ausgehend von den vorbezeichneten Nachteilen der konduktiven Temperierungsvorrichtung aus dem Stand der Technik stellt sich die vorliegende Erfindung die Aufgabe, eine verbesserte Temperierungsvorrichtung zur Temperierung von Objekten bereitzustellen, welche eine verbesserte Wärmeübertragungsleistung bei gleichzeitig geringerem Teilaufwand realisieren kann und wobei eine verbesserte Integrationsmöglichkeit realisiert wird.

Erfindungsgemäß gelöst wird die vorbezeichnete Aufgabe gemäß einem ersten Aspekt der Erfindung durch eine Gegenstromtemperierungsvorrichtung zur Temperierung mindestens eines Objektes. Die erfindungsgemäße Gegenstromtemperierungsvorrichtung umfasst mindestens einen ersten Temperierabschnitt mit mindestens einem ersten Strömungskanal mit einem Kanalquerschnitt zur Durchströmung mit einem ersten Temperiermittel in einer ersten Strömungsrichtung von einem ersten Kanaleintritt zu einem ersten Kanalaustritt entlang eines ersten Strömungsverlaufs und mindestens einen zweiten Temperierabschnitt mit mindestens einem zweiten Strömungskanal mit einem Kanalquerschnitt zur Durchströmung mit einem zweiten Temperiermittel in einer zweiten Strömungsrichtung von einem zweiten Kanaleintritt zu einem zweiten Kanalaustritt entlang eines zweiten Strömungsverlaufs. Die erste Strömungsrichtung des mindestens einen ersten Strömungskanals des mindestens einen ersten Temperierabschnitts ist im Wesentlichen entgegengesetzt zu der zweiten Strömungsrichtung des mindestens einen zweiten Strömungskanals des mindestens einen zweiten Temperierabschnitts verlaufend ausgebildet. Der mindestens eine erste und zweite Strömungskanal steht mit mindestens einem zu temperierenden Oberflächenabschnitt des mindestens einen zu temperierenden Objekts wärmeleitend in Verbindung.

Die wärmeleitende Verbindung kann zwischen dem mindestens einen zu temperierenden Objekt sowohl zum mindestens einen ersten Strömungskanal als auch mindestens einen zweiten Strömungskanal
entweder
durch direkten Oberflächenkontakt des mindestens einen ersten Strömungskanals und des mindestens einen zweiten Strömungskanals mit der Oberfläche des mindestens einen zu temperierenden Objekts etabliert werden,
   oder/und
auf indirektem Weg über ein wärmeleitendes Mittel zwischen der Oberfläche des mindestens einen zu temperierenden Objekts und der bzw. den Oberflächen des mindestens einen ersten Strömungskanals und dem mindestens einen zweiten Strömungskanal etabliert werden.

Das wärmeleitende Mittel kann durch mindestens eine wärmeleitfähige, spaltfüllende Masse gebildet werden und/oder durch mindestens eine wärmeleitfähige Schicht gebildet werden, welche vorzugsweise eine wärmeleitfähige Folie ist. Erfindungsgemäß kann das wärmeleitende Mittel ebenfalls durch mindestens eine wärmeleitfähige Platte, vorzugsweise gebildet aus einem metallischen Blech oder wärmeleitfähige Platte aus einem polymeren Werkstoff, gebildet werden. Die zu temperierenden Objekte können bei Vorsehung von wenigstens zwei zu temperierender Objekte zumindest ein zu temperierendes Objekt selbst als wärmeleitendes Mittel nutzen und die Wärmeleitung zwischen benachbarten Objekten und dem mindestens einen ersten Strömungskanal und dem mindestens einen zweiten Strömungskanal sicher stellen.

Der mindestens eine erste oder mindestens eine zweite Strömungskanal kann zur Wärmeleitung unmittelbar an einer Oberfläche des mindestens einen zu temperierenden Objektes bzw. an einem Oberflächenabschnitt des mindestens einen zu temperierenden Objekts anliegen. Es kann erfindungsgemäß aber auch vorgesehen werden, zwischen den Strömungskanälen und dem mindestens einen zu temperierenden Objekt ein Wärmeleitelement anzuordnen oder beispielsweise eine wärmevermittelnde bzw. wärmeleitende Paste oder Flüssigkeit einzubringen.

Erfindungsgemäß kann es vorgesehen sein, dass der mindestens eine erste Temperierabschnitt und der mindestens eine zweite Temperierabschnitt in einem einzigen singulären Temperierkreislauf eingebunden sind und in diesem zueinander fluidisch parallelgeschaltet sind. Alternativ können der mindestens eine erste und der mindestens eine zweite Temperierabschnitt in fluidisch voneinander getrennten unterschiedlichen Temperierkreisläufen eingebunden werden.

Im Rahmen der vorliegenden Erfindung soll das Merkmal "fluidisch parallelgeschaltet" dahingehend verstanden werden, dass der mindestens eine erste und mindestens eine zweite Temperierabschnitt lediglich gleichzeitig und parallel zueinander mit einem Temperiermittel durchströmt werden. Das Merkmal soll nicht erfindungsgemäß dahingehend missverstanden werden, dass die Strömungsrichtung des mindestens einen ersten und zweiten Temperierabschnitts zwingend geometrisch alle gleich seien oder zwingend parallel verlaufen müssen. Diesbezüglich ist die geometrische Strömungsrichtung völlig unabhängig von der fluidischen Schaltung bzw. Verbindung der Elemente.

Als Temperiermedium kann bevorzugt ein flüssiges Medium, wie beispielsweise Wasser, ein mehrwertiger Alkohol, Glykol, ein Öl oder bevorzugt ein Wärmeträgeröl bzw. ein Gemisch aus den vorbezeichneten Medien genutzt werden. Erfindungsgemäß kann es jedoch ebenfalls vorgesehen werden, dass als Temperiermedium ein gasförmiges Medium, wie beispielsweise auch Luft, verwendet werden kann.

Weiterhin kann es vorgesehen sein, dass eine Mehrzahl erster Strömungskanäle ausgebildet sind, die fluidtechnisch parallelgeschaltet miteinander verbunden sind zur gleichzeitigen Durchströmung der Mehrzahl an ersten Strömungskanälen mit dem ersten Temperiermittel und/oder wobei eine Mehrzahl zweiter Strömungskanäle ausgebildet sind, die fluidtechnisch parallelgeschaltet miteinander verbunden sind zur gleichzeitigen Durchströmung der Mehrzahl an zweiten Strömungskanälen mit dem zweiten Temperiermittel.

Das erste und zweite Temperiermittel können erfindungsgemäß zu ein und demselben Temperiermittel und damit auch zu demselben Temperiermittelkreislauf gehören, welches vor dem Erreichen des ersten und zweiten Temperierkreislaufabschnitts in ein erstes und zweites Temperiermittel aufgeteilt wird.

Der mindestens eine erste und der mindestens eine zweite Temperierabschnitt können zu voneinander fluiddicht getrennten Temperierkreisläufen der Anwendung gehören, womit das erste und zweite Temperiermittel voneinander getrennt und unabhängig sind.

Erfindungsgemäß kann es vorgesehen werden, dass die mindestens zwei zu temperierenden Oberflächenabschnitte, mit dem der mindestens eine erste und zweite Strömungskanal wärmeleitend in Verbindung steht, untereinander wärmeleitend in Verbindung stehen, entweder darüber, dass die beiden Oberflächen des mindestens einen ersten und zweiten Strömungskanals Teiloberflächenabschnitte des zu temperierenden Oberflächenabschnitts einer gemeinsamen Oberfläche sind oder darüber, dass die beiden Oberflächen des mindestens einen ersten und zweiten Strömungskanals über das zu temperierende Objekt oder über eine Anordnung von mehreren zu temperierenden Objekten hindurch oder herum wärmeleitend miteinander in Verbindung stehen.

Weiterhin kann es vorgesehen werden, dass die erfindungsgemäße Temperiervorrichtung weiterhin mindestens einen ersten Temperiermitteleinlass sowie mindestens einen ersten Verteilerkanal zur Verbindung mindestens zweier erster Temperiermitteleintritte von mindestens zwei ersten Strömungskanälen mit dem mindestens einen ersten Temperiermitteleinlass der Vorrichtung und/oder umfassend mindestens einen zweiten Temperiermitteleinlass sowie mindestens einen zweiten Verteilerkanal zur Verbindung mindestens zweier zweiter Temperiermitteleintritte von mindestens zwei zweiten Strömungskanälen mit dem mindestens einen zweiten Temperiermitteleinlass der Vorrichtung umfasst.

Die Strömungskanäle, der mindestens eine Verteilerkanal und/oder der mindestens eine Rücklaufkanal können aus einem polymeren und/oder aus einem metallischen Werkstoff gebildet werden.

Die erfindungsgemäße Gegenstromtemperierungsvorrichtung kann weiterhin mindestens einen ersten Temperiermittelauslass sowie mindestens einen ersten Rücklaufsammelkanal zur Verbindung mindestens zweier erster Temperiermittelaustritte von mindestens zwei ersten Strömungskanälen mit dem mindestens einen ersten Temperiermittelauslass der Vorrichtung und/oder mindestens einen zweiten Temperiermittelauslass sowie mindestens einen zweiten Rücklaufsammelkanal zur Verbindung mindestens zweier zweiter Temperiermittelaustritte von mindestens zwei zweiten Strömungskanälen mit dem mindestens einem zweiten Temperiermittelauslass zur Vorrichtung umfassen.

Es kann vorgesehen werden, dass der mindestens eine erste Temperiermitteleinlass bzw. erste Verteilerkanal dem mindestens einen ersten Temperiermittelauslass bzw. ersten Rücklaufsammelkanal in einer ersten Ebene parallel zu der ersten Strömungsrichtung gegenüberliegt und der mindestens eine zweite Temperiermitteleinlass bzw. zweite Verteilerkanal dem mindestens einen zweiten Temperiermittelauslass bzw. zweiten Rücklaufsammelkanal in der ersten Ebene gegenüberliegt, wobei der mindestens eine erste Temperiermitteleinlass bzw. erste Verteilerkanal dem wenigstens einen zweiten Temperiermittelauslass bzw. zweiten Rücklaufsammelkanal relativ zu der ersten Ebene gegenüberliegt und der wenigstens eine zweite Temperiermitteleinlass bzw. zweite Verteilerkanal dem wenigstens einen ersten Temperiermittelauslass bzw. ersten Rücklaufsammelkanal relativ zu der ersten Ebene gegenüberliegt, wodurch das Temperiermittel in dem wenigstens einen ersten Strömungskanal in entgegengesetzter Richtung zum wenigstens einen zweiten Strömungskanal fließt.

Erfindungsgemäß ist vorgesehen, dass der mindestens eine erste und zweite Temperierabschnitt nur über einen Zulauf und nur über einen Rücklauf an den Temperierkreislauf der Anwendung angebunden sind, in dem der wenigstens eine erste Temperiermitteleinlass des ersten Temperierabschnitts und der zweite Temperiermitteleinlass des zweiten Temperierabschnitts mit einem gemeinsamen Zulauf an den Temperierkreislauf der Anwendung angebunden sind und wobei der mindestens eine erste Temperiermittelauslass des ersten Temperierabschnitts und der zweite Temperiermittelauslass des zweiten Temperierabschnitts mit einem gemeinsamen Rücklauf an den Temperierkreislauf der Anwendung angebunden sind.

Die vorbezeichnete Ausführungsform bewirkt, dass sich das Temperiermittel vor dem Durchströmen entsprechend der Anzahl an Temperierabschnitten in wenigstens ein erstes Temperiermittel und wenigstens ein zweites Temperiermittel aufteilt und nach dem Durchströmen der Temperierabschnitte das erste und zweite Temperiermittel wieder zu einem gemeinsamen Temperiermittel im gemeinsamen Rücklauf eingeführt werden.

Erfindungsgemäß kann es vorgesehen werden, dass eine Mehrzahl erster und zweiter Strömungskanäle vorgesehen wird, wobei die ersten und zweiten Strömungskanäle entlang der zu temperierenden Objekte im Wesentlichen geometrisch parallel zueinander verlaufend angeordnet sind und die ersten und zweiten Strömungskanäle weiterhin in einer gemeinsamen Anordnungsebene orthogonal zu den Strömungsverläufen abwechselnd angeordnet sind.

Es kann weiterhin vorgesehen werden, dass eine Mehrzahl erster und zweiter Strömungskanäle ausgebildet wird, wobei die ersten Strömungsverläufe der Strömungskanäle im Wesentlichen parallel zueinander verlaufen und die ersten Strömungskanäle in einer ersten Anordnungsebene angeordnet sind, wobei die zweiten Strömungsverläufe der Strömungskanäle im Wesentlichen parallel zueinander verlaufen und die zweiten Strömungskanäle in einer zweiten Anordnungsebene angeordnet sind, wobei die erste Anordnungsebene in orthogonaler Richtung zur zweiten Anordnungsebene beabstandet ist.

Weiterhin kann es vorgesehen werden, dass zwischen den in der gemeinsamen Anordnungsebene oder in der jeweiligen ersten und/oder zweiten Anordnungsebene angeordneten jeweils benachbarten ersten und/oder zweiten Strömungskanäle ein Aufnahmeraum zur Anordnung mindestens eines konduktiv zu temperierenden Objekts ausgebildet ist, wobei ein erster Strömungskanal und ein zweiter Strömungskanal wärmeleitend mit dem mindestens einen zu temperierenden Objekt in Verbindung steht.

Das zu temperierende Objekt kann zumindest zwei zu temperierende erste und zweite Oberflächenabschnitte umfassen, wobei ein erster Strömungskanal zumindest teilweise wärmeleitend mit dem ersten Oberflächenabschnitt und ein zweiter Strömungskanal zumindest teilweise wärmeleitend mit dem zweiten Oberflächenabschnitt in Verbindung stehend ausgebildet werden kann.

Es kann vorgesehen werden, dass die in der gemeinsamen Anordnungsebene oder in der jeweiligen ersten und/oder zweiten Anordnungsebene angeordneten jeweils zumindest unmittelbar benachbarten ersten und/oder zweiten Strömungskanäle aneinander angrenzend oder zumindest in geringerem Abstand als deren Strömungskanalbreite in gleicher Ebene und gleicher Richtung beabstandet ausgestaltet sind zur Ausbildung einer gemeinsamen wärmeleitenden Haupttemperierfläche für die Anlage an mindestens ein zu temperierendes Objekt bzw. an mindestens eine Anordnung mehrerer zu temperierender Objekte.

Weiterhin kann es vorgesehen werden, dass alle ersten und zweiten Strömungskanäle in der gemeinsamen Anordnungsebene oder in der respektive ersten und/oder zweiten Anordnungsebene unmittelbar aneinander angrenzend ausgestaltet sind zur Ausbildung mindestens einer wärmeleitenden Gesamttemperierfläche für die Anlage an mindestens ein zu temperierendes Objekt bzw. an mindestens eine Anordnung mehrerer zu temperierender Objekte.

Es kann vorgesehen werden, dass der mindestens eine erste und/oder zweite Strömungskanal in einer Ebene parallel zu dem Strömungsverlauf abgeflacht ausgestaltet ist zur Ausbildung einer wärmeleitenden Anlagefläche für mindestens ein konduktiv zu temperierendes Objekt.

Bei einer erfindungsgemäßen Gegenstromtemperierungsvorrichtung kann die Anzahl der ersten Strömungskanäle bis auf plus-minus einen Strömungskanal identisch mit der Anzahl der zweiten Strömungskanäle ausgebildet werden.

Die Anzahl der ersten Strömungskanäle und die Anzahl der zweiten Strömungskanäle kann jeweils vorzugsweise der Anzahl von Reihen der in Reihen angeordneten Objekte, entlang der sich die Strömungskanäle erstrecken, bis auf plus-minus einen Strömungskanal entsprechen.
oder
die Anzahl der ersten Strömungskanäle und die Anzahl der zweiten Strömungskanäle kann auf plus-minus einen Strömungskanal jeweils einem ganzzahligen Bruchteil der Objekt-Reihen, entlang der sich die Strömungskanäle erstrecken, entsprechend ausgebildet werden.
   oder
die Anzahl der ersten Strömungskanäle und die Anzahl der zweiten Strömungskanäle kann auf plus-minus einen Strömungskanal jeweils einem ganzzahligen Vielfachen der Objekt-Reihen, entlang der sich die Strömungskanäle erstrecken, entsprechen.

Erfindungsgemäß kann es auch vorgesehen werden, dass zumindest die ersten und/oder zweiten Strömungskanäle aus mindestens zwei Lagen ausgebildet sind, wobei mindestens zwei Lagen entweder aus mindestens zwei einzelnen Teilen oder aus mindestens zwei Teilabschnitten eines Teils gebildet sind, die miteinander, vorzugsweise aufeinander, gestapelt oder aufeinander gefaltet in Teilbereichen miteinander verbunden sind, zur Ausbildung der Mehrzahl an gegenüber der Umgebung fluiddicht begrenzten Strömungskanälen.

Die Lagen können aus beispielsweise aus im Wesentlichen flachen Teilen, nachfolgend auch als Flachteile bezeichnet, gebildet werden, deren Flächenabmessungen, zumindest in einer Flächenrichtung, ein Vielfaches der Höhen- oder Dickenabmessung aufweisen, die aber dennoch eine für die Funktion erforderliche dreidimensionale Geometrie aufweisen oder im Betrieb annehmen können, um beispielsweise das Temperiermittelvolumen mit zumindest den Strömungskanälen bilden zu können, oder um Befestigungsbereiche in Form von beispielsweise Rippen oder Schraubdomen, insbesondere bei Verwendung eines formgebenden Herstellungsverfahrens wie z.B. Metall- oder Kunststoff-Spritzguss oder Spritzprägen, darzustellen.

Alternativ kann auch eine umgefaltete singuläre/einzelne Lage eines Flachbahnmaterials den ersten und/oder zweiten Strömungskanal ausbilden, wobei die Lagen in Teilbereichen miteinander verbunden sind zur Ausbildung der Mehrzahl an gegenüber der Umgebung fluiddicht begrenzten Strömungskanälen. Als Flachbahnmaterial kann besonders bevorzugt ein Metallblech oder/und eine metallische oder/und polymere oder/und elastomere Folie im Rahmen der vorliegenden Erfindung Verwendung finden.

Alternativ können auch aus einem singulären, in einem formgebenden Herstellungsverfahren hergestellten, Bauteil bzw. Flachteil, welches beispielsweise eine komplexere dreidimensionale Geometrie aufweist, die mindestens zwei Lagen gebildet werden, indem das Bauteil wenigstens einen dünnen flexiblen Bereich, vorzugsweise in Form eines Filmscharniers, aufweist, über den sich das Bauteil umfalten lässt. Mit mindestens zwei dünnen flexiblen Bereichen, vorzugsweise als Filmscharniere, die so angeordnet sind, dass z.B. ein Z-förmiges, d.h. alternierendes Falten, möglich ist, lassen sich entsprechend auch mindestens drei Lagen mit einem Bauteil realisieren.

Um die Vorteile eines Flachbahnmaterials bzgl. Dünnwandigkeit und Wärmeleitfähigkeit und die Vorteile eines formgebenden Materials bzgl. größerer Designfreiheit zu kombinieren, ist es besonders bevorzugt, beide Materialien in Kombination entweder über einen Mischverbau von Flachteilen aus einem Flachbahnmaterial in Kombination mit Flachteilen aus einem formgebenden Material einzusetzen oder als Hybrid-Flachteile einzusetzen, die bereichsweise aus einem Flachbahnmaterial und einem formgebenden Material gebildet sind.

Die ersten und zweiten Strömungskanäle können alternativ jeweils als Extrusionsprofil oder auch als Tauchformkörper ausgebildet werden.

Die ersten und die zweiten Strömungskanäle und der wenigstens eine erste und/oder der wenigstens eine zweite Verteilerkanal und/oder der wenigstens eine erste und/oder der wenigstens eine zweite Rücklaufsammelkanal können durch wenigstens drei übereinander, in Teilbereichen zur Ausbildung bzw. Abgrenzung der einzelnen Kanäle gefügte Lagen, gebildet werden.

Das Aufteilen des Temperiermittels nach dem gemeinsamen Zulauf in ein erstes und zweites Temperiermittel kann über einen ersten Temperiermitteleinlass des ersten Temperierabschnitts und über einen zweiten Temperiermitteleinlass des zweiten Temperierabschnitts erfolgen, wobei sich der eine erste und der eine zweite Temperiermitteleinlass innerhalb der aus den drei Lagen gebildeten Baugruppe befindet.

Das Zusammenführen des einen ersten Temperiermittels und des einen zweiten Temperiermittels vor dem gemeinsamen Rücklauf kann über einen ersten Temperiermittelauslass des ersten Temperierabschnitts und über einen zweiten Temperiermittelauslass des zweiten Temperierabschnitts erfolgen, wobei sich der eine erste und der eine zweite Temperiermittelauslass innerhalb der aus den drei Lagen gebildeten Baugruppe befindet.

Die mindestens zwei Lagen oder die mindestens drei Lagen können durch Flachteile gebildet werden, deren überspannte Flächenabmessungen zumindest in einer Flächenrichtung mehr als das 10-fache, vorzugsweise mehr als das 100-fache, der Lagen- bzw. Flachteil-Wandstärke betragen, wobei wenigstens die Lage oder die Lagen bzw. das Flachteil oder die Flachteile aus einem dünnwandigen, d.h. weniger als 3 mm dicken, vorzugsweise weniger als 1 mm dicken, besonders bevorzugt weniger als 0,5 mm dicken, metallischem oder/und polymeren oder/und elastomeren wärmeleitfähigen Werkstoff hergestellt sind, die den zu temperierenden Objekten zugewandt sind.

Zumindest die Lagen bzw. Flachteile, die den zu temperierenden Objekten zugewandt sind, können aus einem dünnen Flachbahnmaterial wie z.B. wenigstens einem Metallformblech oder/und einer polymeren oder/und elastomeren oder/und einer metallischen Folie bestehen oder zumindest ein solches Flachbahnmaterial als Bestandteil eines Verbund- bzw. Hybridbauteils umfassen.

Die den zu temperierenden Objekten abgewandten Lagen bzw. Flachteile können aus einem dünnen Flachbahnmaterial, wie z.B. wenigstens einem Metallformblech oder/und einer polymeren oder/und elastomeren oder/und metallischen Folie bestehen, oder aus einer metallischen oder polymeren Formmasse hergestellt werden, oder als Hybridbauteil aus einem Flachbahnmaterial und einer an dieses angeformten Formmasse hergestellt sein.

Gemäß einem zweiten Aspekt betrifft die vorliegende Erfindung ein Batteriegehäuse zur Aufnahme mindestens einer Batteriezelle umfassend eine erfindungsgemäße Gegenstromtemperierungsvorrichtung gemäß dem ersten Aspekt der vorliegenden Erfindung.

Weiterhin betrifft die vorliegende Erfindung gemäß einem dritten Aspekt die Verwendung einer erfindungsgemäßen Gegenstromtemperierungsvorrichtung gemäß dem ersten Aspekt zur Temperierung von elektrischen Komponenten wie beispielsweise elektrischer Energiespeicher und/oder elektrischer Schaltungen.

Bevorzugt kann die Gegenstromtemperierungsvorrichtung zur Temperierung elektrischer Energiespeicher in Form von Rundzellen, quaderförmiger prismatischer Zellen oder flacher taschenförmiger Batteriezellen Verwendung finden, wobei zumindest ein erster und zweiter Strömungskanal an zumindest einem Teilbereich einer Außenwandung des zu temperierenden Energiespeichers anliegt und/oder zumindest wärmeleitend mit dem zu temperierenden Energiespeicher in Verbindung steht.

Weiterhin kann eine Verwendung zur Temperierung von Energiespeichern einer stationären Anwendung eines boden-, see- oder luftgebundenen Fahrzeugs erfindungsgemäß vorgesehen werden.

Im Nachfolgenden werden unter Bezugnahme auf die beigefügten Figuren beispielhafte Ausführungsformen der erfindungsgemäßen Gegenstromtemperierungsvorrichtung erläutert. Die Bezugszeichen sind über alle Ausführungsformen vereinheitlicht dargestellt, so dass Funktionsbereiche mit gleicher oder zumindest vergleichbarer Funktion dasselbe Bezugszeichen tragen. Sollte ein Bezugszeichen zu einer Ausführungsform nicht beschrieben sein, so lässt sich dessen Bezeichnung und Funktion entsprechend der Figurenbeschreibung einer anderen Ausführungsform sinngemäß entnehmen.

Es zeigen:
- Fig. 1A: schematische Aufsichten auf den ersten und zweiten Temperierabschnitt einer ersten beispielhaften Ausführungsform einer Gegenstromtemperierungsvorrichtung in Einzelansicht;
- Fig. 1B: die schematische Aufsicht auf die erste beispielhafte Ausführungsform einer Gegenstromtemperierungsvorrichtung umfassend einen ersten und zweiten Temperierabschnitt gemäß Fig. 1A;
- Fig. 2A: perspektivische Ansichten eines ersten und eines zweiten Temperierabschnitts einer zweiten beispielhaften Ausführungsform einer Gegenstromtemperierungsvorrichtung in Einzelansicht;
- Fig. 2B: eine perspektivische Ansicht der Gegenstromtemperierungsvorrichtung umfassend einen ersten und zweiten Temperierabschnitt gemäß Fig. 2A in Zusammenstellung;
- Fig. 2C: die Gegenstromtemperierungsvorrichtung gemäß Figuren 2A und 2B in Aufsicht mit beispielhaft dargestellten zu temperierenden Objekten;
- Fig. 3A: eine perspektivische Ansicht einer weiteren beispielhaften Ausführungsform einer erfindungsgemäßen Gegenstromtemperierungsvorrichtung;
- Fig. 3B: eine teilweise zerlegte perspektivische Darstellung der Einzelteile der Gegenstromtemperierungsvorrichtung gemäß Fig. 3A;
- Fig. 3C: weitere Schnitt- und Detailansichten der erfindungsgemäßen Gegenstromtemperierungsvorrichtung gemäß Figuren 3A und 3B;
- Fig. 4A: eine perspektivische Darstellung auf eine weitere beispielhafte Ausführungsform der erfindungsgemäßen Gegenstromtemperierungsvorrichtung;
- Fig. 4B: eine weitere perspektivische Darstellung der Ausführungsform gemäß Fig. 4A der erfindungsgemäßen Gegenstromtemperierungsvorrichtung;
- Fig. 4C: eine zerlegte perspektivische Darstellung in die Einzelteile der Gegenstromtemperierungsvorrichtung gemäß Fig. 4A bzw. 4B;
- Fig. 4D: eine weitere zerlegte perspektivische Darstellung in die Einzelteile der Gegenstromtemperierungsvorrichtung gemäß Fig. 4A bzw. 4B;
- Fig. 4E: eine Draufsicht auf die Gegenstromtemperierungsvorrichtung gemäß Fig. 4A bzw. 4B und weitere Schnitt- und Detailansichten;
- Fig. 4F: eine Draufsicht auf die Gegenstromtemperierungsvorrichtung gemäß Fig. 4A bzw. 4B und weitere Schnitt- und Detailansichten;
- Fig. 4G: weitere Schnitt- und Detailansichten der Gegenstromtemperierungsvorrichtung gemäß Fig. 4A bzw. 4B, jedoch mit einer Variante der Zulauf- und Rücklauf-Schnittstellen-Anbindung;
- Fig. 4H: eine beispielhafte Anordnungskonfiguration der Gegenstromtemperierungsvorrichtung gemäß Fig. 4A bzw. 4B und einer ersten zu temperierenden Objektanordnung;
- Fig. 4I: eine weitere beispielhafte Anordnungskonfiguration der Gegenstromtemperierungsvorrichtung gemäß Fig. 4A bzw. 4B, bestehend aus einer ersten und einer zweiten Gegenstromtemperierungsvorrichtung, zwischen denen eine Objektanordnung temperiert wird;
- Fig. 4J: eine weitere beispielhafte Anordnungskonfiguration der Gegenstromtemperierungsvorrichtung gemäß Fig. 4A bzw. 4B und einer ersten zu temperierenden Objektanordnung und einer zweiten zu temperierenden Objektanordnung;
- Fig. 5A: eine perspektivische Darstellung auf eine weitere beispielhafte Ausführungsform der erfindungsgemäßen Gegenstromtemperierungsvorrichtung;
- Fig. 5B: eine zerlegte perspektivische Darstellung in die Einzelteile der Gegenstromtemperierungsvorrichtung gemäß Fig. 5A;
- Fig. 5C: eine Detailansicht auf die innere Lage 43C;
- Fig. 5D: eine Draufsicht auf die Gegenstromtemperierungsvorrichtung gemäß Fig. 5A mit exemplarisch dargestellten, zu temperierenden Objekten, und weitere Schnitt- und Detailansichten;
- Fig. 5E: ein beispielhafter Ausschnitt einer Anordnungskonfiguration der Gegenstromtemperierungsvorrichtung gemäß. Fig. 5A und einer zu temperierenden Objektanordnung;
- Fig. 6A: eine perspektivische Darstellung auf eine weitere beispielhafte Ausführungsform der erfindungsgemäßen Gegenstromtemperierungsvorrichtung;
- Fig. 6B: eine Draufsicht auf die Gegenstromtemperierungsvorrichtung gemäß Fig. 6A mit exemplarisch dargestellten, zu temperierenden Objekten, und eine weitere Schnitt- und Detailansicht; und
- Fig. 6C: eine Seitenansicht auf die Gegenstromtemperierungsvorrichtung gemäß Fig. 6A und eine weitere Schnitt- und Detailansicht.

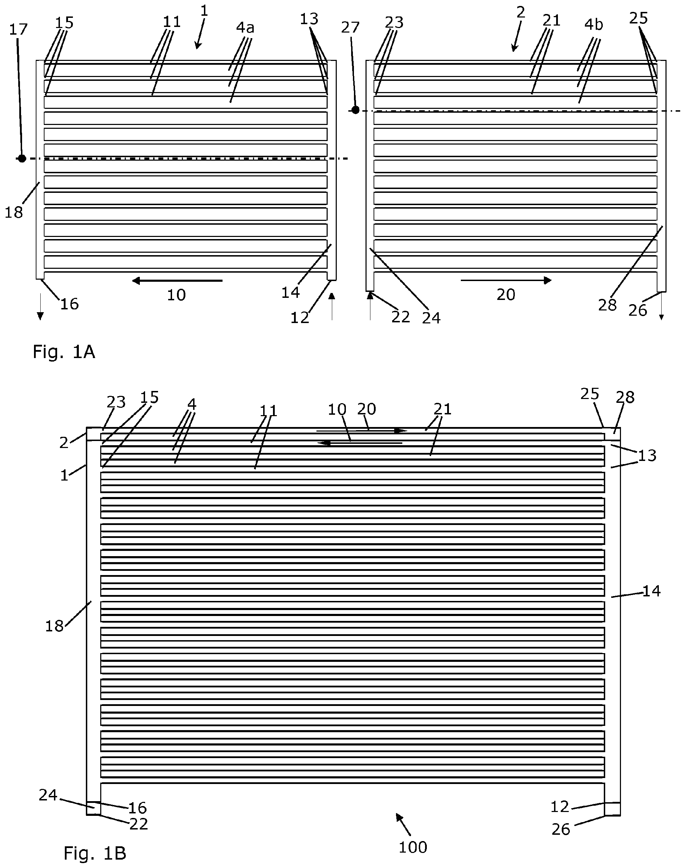

Die Fig. 1A zeigt die Einzelansichten eines ersten Temperierabschnitts 1 sowie eines zweiten Temperierabschnitts 2 einer erfindungsgemäßen Gegenstromtemperierungsvorrichtung 100 zur Temperierung mindestens eines Objektes 3. Die Gegenstromtemperierungsvorrichtung 100 umfasst einen ersten Temperierabschnitt 1 sowie einen zweiten Temperierabschnitt 2, welche in der Fig. 1A zur besseren Nachvollziehbarkeit der realisierten Merkmale in Einzelansicht dargestellt sind. Der erste Temperierabschnitt 1 weist mindestens einen ersten Strömungskanal 11 auf. In der dargestellten Ausführungsform umfasst der erste Temperierabschnitt 1 die beispielhafte Anzahl von vierzehn ersten Strömungskanälen 11 zur Durchströmung mit einem ersten Temperiermittel in einer ersten Strömungsrichtung 10 von einem ersten Kanaleintritt 13 zu einem ersten Kanalaustritt 15 entlang eines ersten Strömungsverlaufes 17. Der erste Strömungsverlauf ist in der Fig. 1A als strichpunktierte Linie mit Bezugszeichen 17 verdeutlicht.

In der folgenden Figurenbeschreibung werden die zu temperierenden Objekte mit beliebiger Form dem Bezugszeichen 3 zugeordnet, als Beispiele derartiger zu temperierender Objekte wird mit Bezugszeichen 3a ein im Wesentlichen zylindrisches Objekt und mit 3b ein im Wesentlichen prismatisches Objekt bezeichnet. Die Objekte 3a und 3b werden nur beispielhaft dargestellt und stehen exemplarisch für zu temperierende Objekte 3 mit einer beliebigen Gestalt.

Der zweite Temperierabschnitt 2 weist wiederum mindestens einen zweiten Strömungskanal 21, in der dargestellten Ausführungsform mit einer Gesamtanzahl von beispielhaften vierzehn zweiten Strömungskanälen 21 zur Durchströmung mit einem zweiten Temperiermittel in einer zweiten Strömungsrichtung 20 von dem ersten Kanaleintritt 23 zu einem gegenüberliegenden zweiten Kanalaustritt 25 entlang eines zweiten Strömungsverlaufs 27 auf. Die erste Strömungsrichtung 10 verläuft im Wesentlichen entgegengesetzt zu der zweiten Strömungsrichtung 20, wie dies in der zusammengesetzten Darstellung der Gegenstromtemperierungsvorrichtung 100 der Fig. 1B entnehmbar ist.

In der dargestellten Ausführungsform gemäß Figuren 1A und 1B umfasst die Gegenstromtemperierungsvorrichtung 100 weiterhin einen ersten Temperiermitteleinlass 12 sowie einen ersten Verteilerkanal 14 zur Verbindung der Mehrzahl der ersten Temperiermitteleintritte 13 mit dem ersten Temperiermitteleinlass 12. Die Vorrichtung 100 umfasst weiterhin einen zweiten Temperiermitteleinlass 22 sowie weiterhin einen zweiten Verteilerkanal 24. Zusätzlich ist in der Gegenstromtemperierungsvorrichtung 100 gemäß Figuren 1A und 1B weiterhin ein erster Temperiermittelauslass 16 sowie ein erster Rücklaufsammelkanal 18 zur Verbindung der Mehrzahl der ersten Temperiermittelaustritte 15 mit dem ersten Temperiermittelauslass 16 sowie weiterhin ein zweiter Temperiermittelauslass 26 sowie ein zweiter Rücklaufkanal 28 zur Verbindung der Mehrzahl der zweiten Temperiermittelaustritte 25 mit dem zweiten Temperiermittelauslass 26 ausgebildet.

In der Gegenstromtemperierungsvorrichtung 100 gemäß den Figuren 1 verlaufen die ersten Strömungsverläufe 17 der ersten Strömungskanäle 11 parallel zueinander, wobei die ersten Strömungskanäle 11 in einer ersten Anordnungsebene angeordnet sind, welche sich orthogonal zu den ersten Strömungsverläufen 17 erstreckt und wobei die zweiten Strömungsverläufe 27 der zweiten Strömungskanäle 21 im Wesentlichen parallel zueinander verlaufen und die zweiten Strömungskanäle 21 in einer zweiten Anordnungsebene angeordnet sind, wobei die erste und zweite Anordnungsebene parallel zueinander ausgerichtet sind.

Mit der beispielhaften Ausführungsform der erfindungsgemäßen Gegenstromtemperierungsvorrichtung 100 gemäß Figuren 1 sind drei unterschiedliche Anordnungskonfigurationen (A, B und C) in Kombination mit den zu temperierenden Objekten 3 erzeugbar, wie nachfolgend ausgeführt werden soll.

### Anordnungskonfiguration A:

In der Anordnungskonfiguration A sind die erste und die zweite Anordnungsebene der Strömungskanäle 11 und 21 parallel zueinander ausgerichtet und gleichzeitig in orthogonaler Richtung zueinander beabstandet. Durch die Beabstandung der ersten und zweiten Anordnungsebene ergibt sich zwischen den Anordnungsebenen und damit zwischen den ersten und zweiten Strömungskanälen 11 und 21 ein Aufnahmeraum, welcher in den Figuren 1 nicht dargestellt ist, in welchem die zu temperierenden Objekte 3 angeordnet werden können. In der Anordnungskonfiguration A werden die zu temperierenden Objekte 3 über zwei im Wesentlichen sich gegenüberliegenden Oberflächen temperiert. Für diese Anordnungskonfiguration sind die Strömungskanäle 11 und 21 vorzugsweise breit in Richtung der jeweiligen Anordnungsebene ausgeführt, so dass ein möglichst großer Flächenanteil und damit möglichst große Haupttemperierflächen 42 realisiert werden. Aus der breiten Ausführung Strömungskanäle 11 und 21 folgt ein entsprechend geringer Flächenanteil der Freiräume 4a und 4b zwischen den Strömungskanälen 11 und 21. Besonders bevorzugt können bei der Anordnungskonfiguration A die Freiräume 4a und 4b entfallen, wobei dann unmittelbar aneinandergrenzende Strömungskanäle 11, 21 je Temperierabschnitt ausgebildet werden.

### Anordnungskonfiguration B:

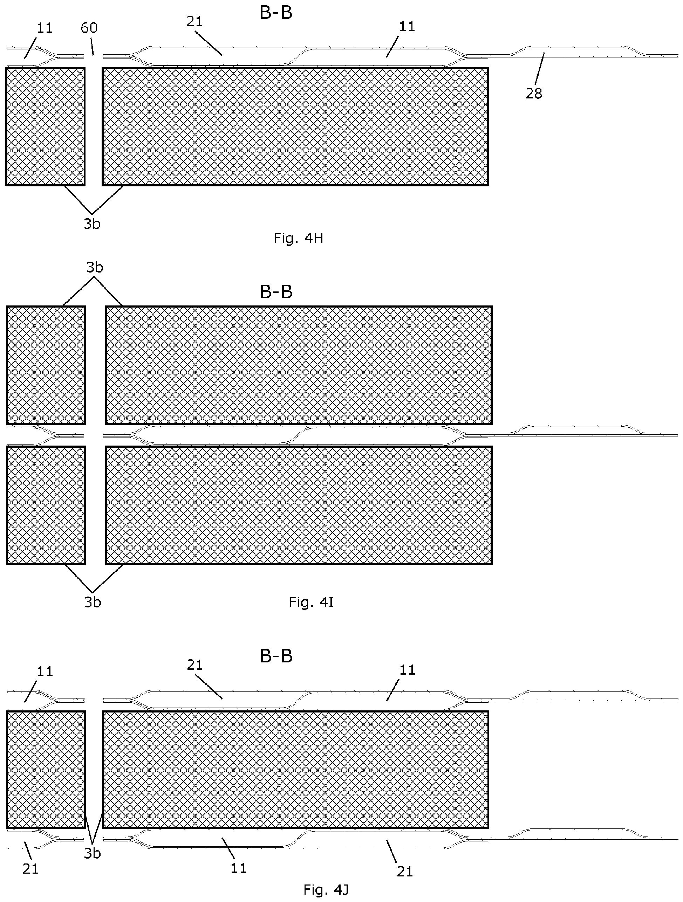

In der Anordnungskonfiguration B sind die erste und die zweite Anordnungsebene der Strömungskanäle 11 und 21 auf ein und derselben Seite des zu temperierenden Objekts 3 bzw. auf ein und derselben Seite der Anordnung der zu temperierenden Objekte 3 parallel zueinander angeordnet und die Strömungskanäle 11 und 21 sind wärmeleitend direkt oder indirekt mit der bzw. den zu temperierenden Oberflächen der Objekte 3 oder Objektanordnung kontaktiert. In der Anordnungskonfiguration B sind die Strömungskanäle 11 und 21 ebenfalls vorzugsweise breit in Richtung der Anordnungsebenen ausgeführt, so dass ein möglichst großer Flächenanteil und damit möglichst große Haupttemperierflächen 42 realisiert sind. Zudem sind bei dieser Ausführungskonfiguration B die Strömungskanäle 11 untereinander beabstandet, wobei die Abstände der Strömungskanäle 11 untereinander vorzugsweise größer ausgeführt sind als die Breite der Strömungskanäle 21, so dass eine wärmeleitende Verbindung der Strömungskanäle 21 mit dem zu temperierenden Objekt 3 bzw. der Objektanordnung über eine Kontaktflächenbreite realisiert ist, die vorzugsweise im Wesentlichen der Breite der Strömungskanäle 21 entspricht. Besonders bevorzugt ist es vorgesehen, dass die Strömungskanäle 11 und 21 jeweils eine geringere Breite aufweisen als die Breite der Freiräume 4a und 4b zwischen den Strömungskanälen 11 und 21. Besonders bevorzugt ist bei dieser ÜbereinanderAnordnung der Temperierabschnitte 1 und 2 vorgesehen, dass zumindest die Kontaktflächen der Strömungskanäle 11 und 21 im Wesentlichen auf eine Ebene gebracht sind. Hierzu kann vorzugsweise die konstruktive Gestaltung derart erfolgen, dass die Strömungskanäle 21 innerhalb der Abstände der Strömungskanäle 11 in Richtung der zu temperierenden Oberfläche verlaufen bzw. abgesenkt sind, oder zumindest die Strömungskanäle 21 aus einem plastisch oder elastisch verformbaren Werkstoff gefertigt sind und die Kontaktflächen der Strömungskanäle 21 auf dieselbe Ebene wie die Kontaktflächen der Strömungskanäle 11 gedrückt sind, und/oder dass zumindest die Strömungskanäle 21 aus einem flexiblem Werkstoff gefertigt sind, der über den hydrostatischen Druck des Temperiermittels sich verformt und die Kontaktflächen der Strömungskanäle 21 durch die Abstände der Strömungskanäle 11 hindurch auf die zu temperierende Fläche oder auf mit den zu temperierenden Objekt(en) 3 wärmeleitend verbundene Flächen gedrückt werden. Die Anordnungskonfiguration B ist auch der vom Wirkprinzip identischen Darstellung der Ausführungsform gemäß Fig. 4H entnehmbar.

Die vorangehend in der Anordnungskonfiguration B beschriebene Gegenstromtemperierung von einer Seite des zu temperierenden Objekts 3 bzw. der Objektanordnung ist sinngemäß auch von zwei sich gegenüberliegenden Seiten des zu temperierenden Objekts 3 bzw. der Objektanordnung möglich, indem eine weitere Paarung von zwei Temperierabschnitten 1, 2 inkl. Strömungskanälen 11, 21 gemäß der vorangehenden Beschreibung auf der gegenüberliegenden Seite des zu temperierenden Objekts 3 bzw. der Objektanordnung angeordnet ist. Im Unterschied zur Anordnungskonfiguration A sind bei dieser Variante der Anordnungskonfiguration B beide mit dem bzw. den Objekten 3 wärmeleitend in Verbindung stehende, sich gegenüberliegende, Haupttemperierflächen 42 jeweils gegenstromtemperiert. Diese erweiterte Anordnungskonfiguration B ist auch der vom Wirkprinzip identischen Darstellung der Ausführungsform gemäß Fig. 4J entnehmbar.

Die vorangehend in der Anordnungskonfiguration B beschriebene Gegenstromtemperierung über einer Seite des wenigstens einen ersten zu temperierenden Objekts 3 bzw. der wenigstens einen ersten Objektanordnung ist erweiterbar über wenigstens ein zweites zu temperierenden Objekt bzw. wenigstens eine zweite Objektanordnung, die wärmeleitend mit der Seite der Strömungskanäle 11, 21 verbunden sind, die der ersten Objektanordnung abgewandt ist. Bei dieser Variante der Anordnungskonfiguration B sind die wenigstens eine erste Objektanordnung und die wenigstens eine zweite Objektanordnung parallel zueinander beabstandet angeordnet und die Strömungskanäle 11, 21 befinden sich innerhalb des Abstands der ersten und zweiten Objektanordnung. Sinngemäß lässt sich dieser Aufbau auch um eine dritte Objektanordnung und weitere Objektanordnungen erweitern, die jeweils auf parallelen Ebenen zueinander angeordnet sind und in orthogonaler Richtung zueinander beabstandet sind und zwischen denen vorzugsweise jeweils Strömungskanäle 11, 21 angeordnet sind und mit den Objektanordnungen wärmeleitend verbunden sind. Diese erweiterte Anordnungskonfiguration B ist auch der vom Wirkprinzip identischen Darstellung der Ausführungsform gemäß Fig. 4I entnehmbar.

### Anordnungskonfiguration C:

In der Anordnungskonfiguration C sind die erste und die zweite Anordnungsebene 1, 2 der Strömungskanäle 11 und 21 parallel zueinander, direkt aneinander angrenzend oder in geringem Abstand zueinander angeordnet, wobei die Strömungskanäle 11 und 21 in dieser Anordnungskonfiguration C vorzugsweise eine geringe Breite aufweisen, so dass die Abstände der Strömungskanäle 11 und 21 jeweils zueinander groß sind und jeweils Freiräume 4a, 4b zwischen den Strömungskanälen 11 und 21 ausgebildet werden. In dieser Anordnungskonfiguration sind die ersten Strömungskanäle 11 zu den zweiten Strömungskanälen 21 vorzugsweise um etwa einen halben Abstand der ersten Strömungskanäle 11 untereinander versetzt angeordnet, so dass die Freiräume 4a, 4b, wie in der Draufsicht gemäß Fig. 1B dargestellt, von den Strömungskanälen 11, 21 gegenseitig in zwei vorzugsweise gleichgroße Aufnahmeräume 4 geteilt werden.

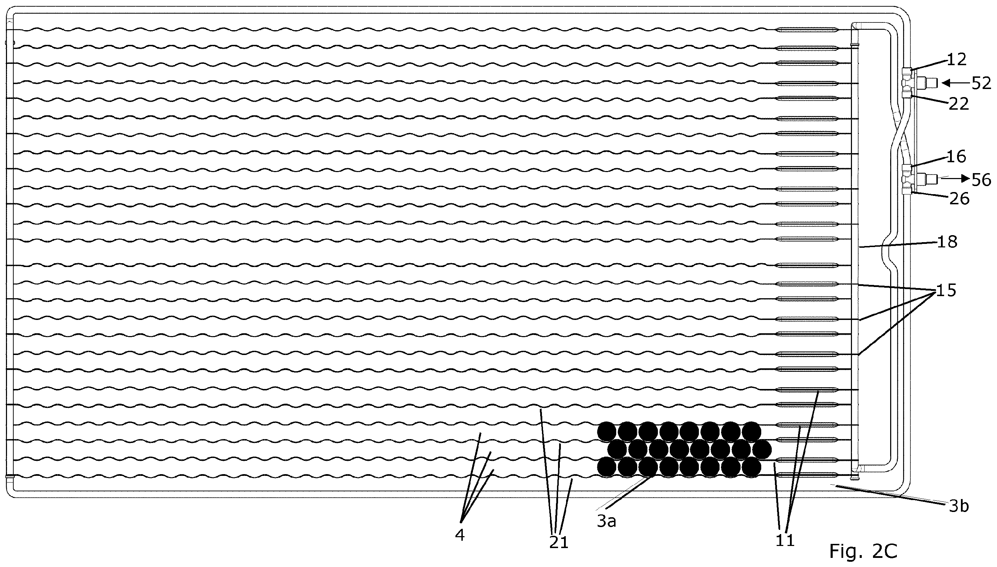

In der Ausführungskonfiguration C der Gegenstromtemperierungsvorrichtung 100 gemäß Fig. 1B wird zwischen den jeweiligen ersten und zweiten Anordnungsebenen 1, 2 der jeweils benachbarten ersten und zweiten Strömungskanäle 11, 21 ein Aufnahmeraum 4 zur Anordnung mindestens eines konduktiv zu temperierenden Objektes 3 ausgebildet, wobei das mindestens eine zu temperierende Objekt 3, welches in Figuren 1 nicht dargestellt ist, zumindest zwei zu temperierende erste und zweite Oberflächenabschnitte umfasst, wobei ein erster Strömungskanal 11 zumindest teilweise wärmeleitend mit dem ersten Oberflächenabschnitt und ein zweiter Strömungskanal 21 zumindest teilweise wärmeleitend mit dem zweiten Oberflächenabschnitt in Verbindung steht, so wie dies beispielhaft in der Fig. 2C im Hinblick auf eine weitere Ausführungsform einer erfindungsgemäßen Gegenstromtemperierungsvorrichtung 100 entnehmbar ist.

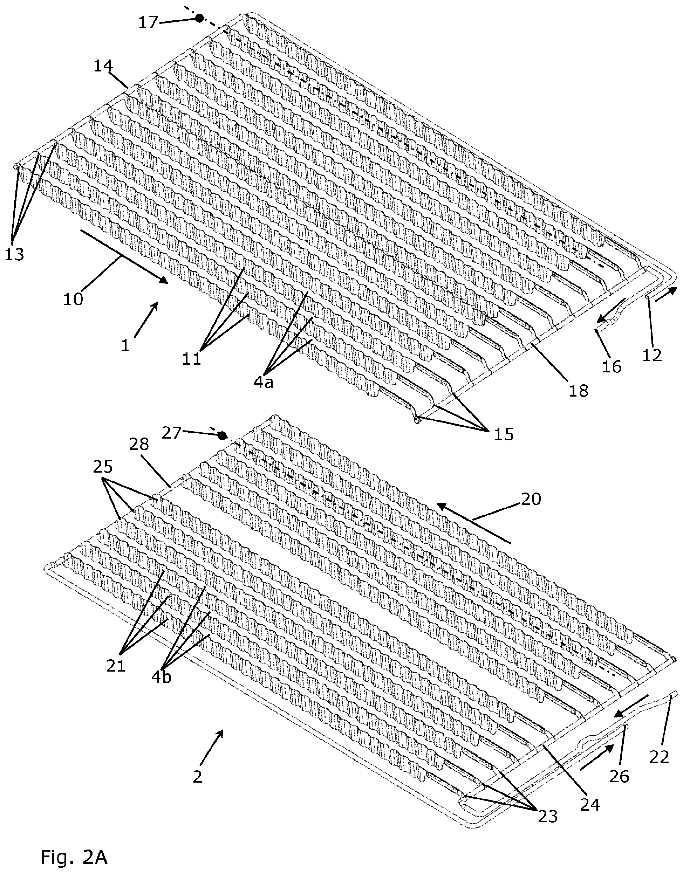

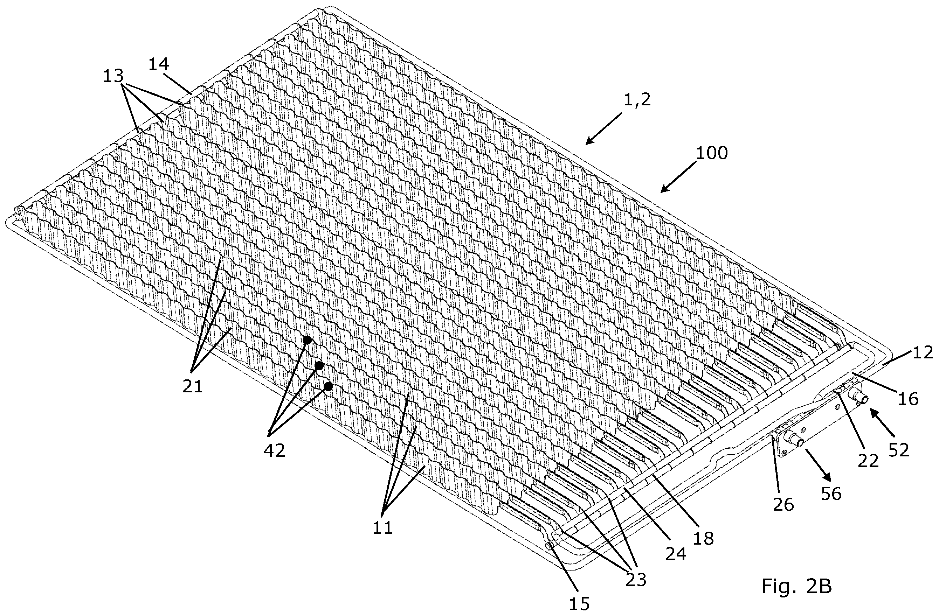

Die Figuren 2 zeigen eine weitere beispielhafte Ausführungsform einer erfindungsgemäßen Gegenstromtemperierungsvorrichtung 100. Die Fig. 2A zeigt dabei jeweils eine perspektivische Einzelansicht des ausgebildeten ersten Temperierabschnitts 1 sowie des zweiten Temperierabschnitts 2. Die Fig. 2B zeigt die erfindungsgemäße Gegenstromtemperierungsvorrichtung 100 gemäß Fig. 2A in Zusammenstellung und die Fig. 2C eine Aufsicht der erfindungsgemäßen Gegenstromtemperierungsvorrichtung 100 gemäß Figuren 2A und 2B mit darin beispielhaft angeordneten, zu temperierenden, Objekten 3.

Die Ausführungsform der erfindungsgemäßen Gegenstromtemperierungsvorrichtung 100 gemäß Figuren 2 weist im Wesentlichen die Merkmale gemäß Figuren 1 insbesondere gemäß Anordnungskonfiguration C auf, jedoch unterscheidet sich die Gegenstromtemperierungsvorrichtung 100 gemäß Figuren 2 von der gemäß Figuren 1 darin, dass die ersten und zweiten Strömungskanäle 11, 21 in einer gemeinsamen Anordnungsebene verlaufen und zwischen den jeweiligen ersten und zweiten benachbarten Strömungskanälen 11, 21 ein Aufnahmeraum 4 zur Anordnung mindestens eines konduktiv zu temperierenden Objektes 3 oder mehrerer zu temperierender Objekte 3 in der gemeinsamen Anordnungsebene ausgebildet wird. Die in der gemeinsamen Anordnungsebene angeordneten, zumindest unmittelbar benachbarten, ersten und zweiten Strömungskanäle 11, 21 sind dabei entlang der zu temperierenden Objekte 3 im Wesentlichen geometrisch parallel zueinander angeordnet und die ersten und zweiten Strömungskanäle 11, 21 sind zudem in einer gemeinsamen Anordnungsebene orthogonal zu den Strömungsverläufen abwechselnd angeordnet.

In der beispielhaften Ausführungsform gemäß den Figuren 2 sind die ersten und zweiten Strömungskanäle 11, 21 in einer Ebene parallel zu den Strömungsverläufen 17, 27 abgeflacht ausgestaltet zur Ausbildung von wärmeleitenden Haupttemperierflächen 42 für ein weiteres, sich über mehrere Strömungskanäle erstreckendes, konduktiv zu temperierendes Objekt 3b. Wie dies ebenfalls den Figuren 2 entnehmbar ist, sind die Strömungsverläufe 17, 27 der ersten und zweiten Strömungskanäle 11, 21 entlang dem Strömungsverlauf 17, 27 gewellt ausgestaltet, um den Strömungsverlauf 17, 27 an die aufzunehmenden, zu temperierenden, Objekte 3 anzupassen, wie dies der Fig. 2C entnehmbar ist. Besonders bevorzugt ist die Wahl eines flexiblen Werkstoffs für die Strömungskanäle 11, 21, wodurch diese sich dem Anordnungsverlauf der zu temperierenden Objekte anpassen können und wodurch diese sich zusätzlich spaltfrei an die zu temperierenden Objekte 3 bzw. 3b bzw. eine mit den zu temperierenden Objekten wärmeleitend verbundene Fläche über den hydrostatischen Temperiermitteldruck andrücken. Wie dies ebenfalls der Fig. 2C entnehmbar ist, sind die ersten und zweiten Strömungskanäle 11, 21 mit zu temperierenden Oberflächenabschnitten des mindestens einen zu temperierenden Objektes 3 wärmeleitend in Verbindung gebracht. Das wenigstens eine zu temperierende Objekt 3 weist dabei zumindest einen zu temperierenden ersten und einen zu temperierenden zweiten Oberflächenabschnitt auf, wobei ein Strömungskanal 11 zumindest teilweise wärmeleitend mit dem ersten Oberflächenabschnitt und ein zweiter Strömungskanal 21 zumindest teilweise wärmeleitend mit dem zweiten Oberflächenabschnitt in Verbindung steht. Wie dies der Fig. 2C entnehmbar ist, wird durch die wellenförmige Anordnung der Strömungsverläufe 17, 27 der ersten und zweiten Strömungskanäle 11, 21 eine höhere Packungsdichte der zylinderförmigen, zu temperierenden, Objekte 3 einerseits ermöglicht und andererseits die zu temperierenden ersten und zweiten Oberflächenteilabschnitte erhöht. Im Hinblick auf eine einfache Integration der Gegenstromtemperierungsvorrichtung 100 in den vorzugsweise nur einen Temperierkreislauf der Anwendung sind bei dieser Ausführungsform der wenigstens eine erste Verteilerkanal 14 über den wenigstens einen ersten Temperiermitteleinlass 12 und der wenigstens eine zweite Verteilerkanal 24 über den wenigstens einen zweiten Temperiermitteleinlass 22 strömungsverbunden und werden von einem gemeinsamen Zulauf 52 gespeist. Besonders bevorzugt sind bei dieser Ausführungsform auch der wenigstens eine erste Rücklaufsammelkanal 18 über den wenigstens einen ersten Temperiermittelauslass 16 und der wenigstens eine zweite Rücklaufsammelkanal 28 über den wenigstens einen zweiten Temperiermittelauslass 26 strömungsverbunden und strömen über den wenigstens einen gemeinsamen Rücklauf 56 in den vorzugsweise nur einen Temperierkreislauf der Anwendung zurück.

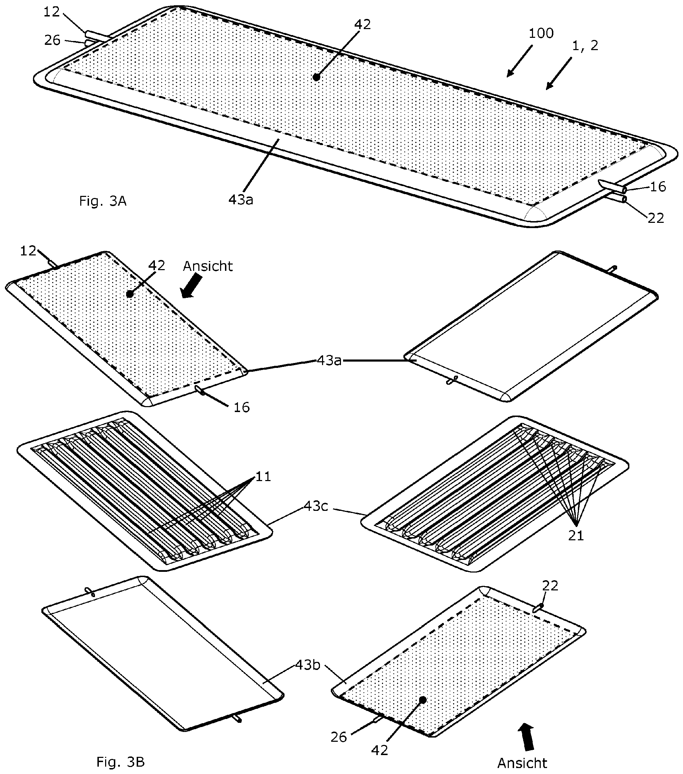

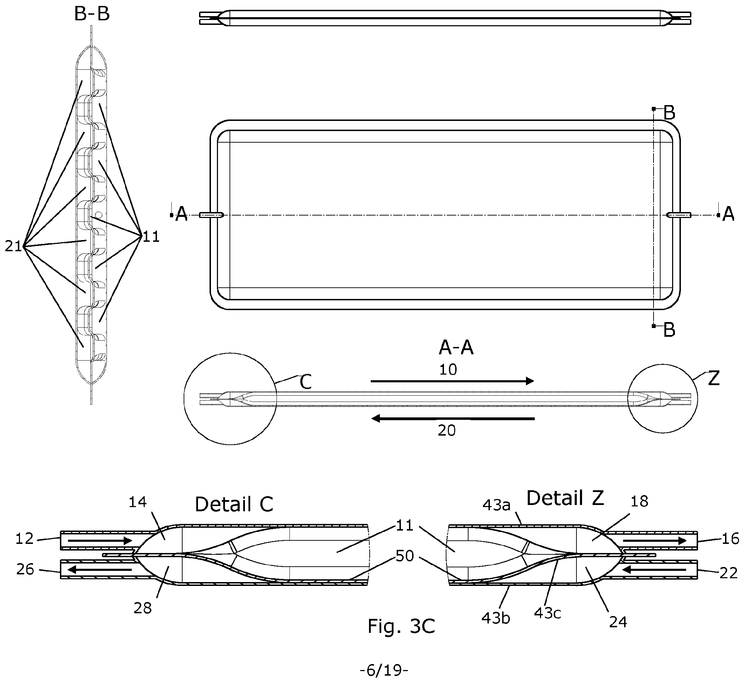

In den Figuren 3A-3C ist eine weitere alternative Ausführungsform einer erfindungsgemäßen Gegenstromtemperierungsvorrichtung 100 dargestellt. Mit dieser Ausführungsform lassen sich in Kombination mit den zu temperierenden Objekten 3 Anordnungskonfigurationen realisieren, die den Varianten der Anordnungskonfiguration B gemäß den Figuren 1 entsprechen. Der wesentliche Unterschied der Ausführungsform gemäß Figuren 3 zur Ausführung gemäß den Figuren 1 ist, dass die Ausführungsform aus einem Temperierabschnitt 1 und einem Temperierabschnitt 2 gebildet sind, die jeweils ihre eigenen Strömungskanäle 11 bzw. 21, ihren wenigstens einen eigenen Verteilerkanal 14 bzw. 24 und ihren wenigstens einen eigenen Rücklaufsammelkanal 18 bzw. 28 umfassen und damit baulich voneinander getrennte Einheiten darstellen. In der Ausführungsform nach den Figuren 3A-3C sind die ersten und zweiten Strömungskanäle 11, 21, sowie Verteilerkanäle 14, 24, sowie Rücklaufsammelkanäle 18, 28 baulich in eine Einheit integriert.

Die beispielhafte Temperiervorrichtung gemäß den Figuren 3A-3C ist aus wenigstens drei flächigen Teilen 43a, 43b, 43c gebildet, deren überspannte Fläche vorzugsweise mindestens der zu temperierenden Fläche entspricht. Die flächigen Teile 43a, 43b, 43c können beispielsweise aus einer Blechtafel gebildet werden. Die drei flächigen Teile 43a, 43b, 43c sind aufeinanderliegend miteinander umlaufend im Randbereich gefügt, so dass zwischen den äußeren flächigen Teilen 43a, 43b ein Gesamtvolumen eingeschlossen wird. Das Gesamtvolumen wird vom mittleren flächigen Teil 43c in wenigstens zwei Teilvolumen aufgeteilt: ein erstes Teil-Volumen zwischen der Lage 43a und der Lage 43c und ein zweites Teil-Volumen zwischen der Lage 43b und 43c. Das erste Teilvolumen bildet das Volumen des mindestens einen ersten Verteilerkanals 14, der mindestens zwei ersten Strömungskanäle 11 und des wenigstens einen ersten Rücklaufkanals 18 und das zweite Teilvolumen bildet das Volumen des mindestens einen zweiten Verteilerkanals 24, der mindestens zwei zweiten Strömungskanäle 21 und des wenigstens einen zweiten Rücklaufkanals 28. Zur Ausbildung der Strömungskanäle 11, 21 im Inneren der Gegenstromtemperierungsvorrichtung 100 ist die innere Lage 43c über mindestens 50 % der überspannten Fläche gewellt ausgeführt und geht über wenigstens eine Welle 50 auf einen wärmeleitenden Kontakt zu der Lage 43b, welches mit wenigstens einer ersten zu temperierenden Objektanordnung wärmeleitend verbunden ist. Durch den Kontakt der wenigstens einen Welle mit einer Lage 43b wird das zweite Teilvolumen im Bereich des Kontakts aufgeteilt, so dass neben dem Kontakt der Welle sich Strömungskanäle 21 ausbilden. Die Anzahl der Strömungskanäle 21 ist abhängig von der Anzahl der Wellen der Lage 43c, die vorzugsweise wärmeleitend mit der Lage 43b in Verbindung stehen. Die Anzahl der Strömungskanäle 11 ist ebenfalls davon abhängig, wie viele Wellen auf der gegenüberliegenden Seite vorzugsweise wärmeleitend mit der Lage 43a in Kontakt stehen. Die Wellen selbst weisen vorzugsweise eine mäanderförmige oder rechteckige oder trapezförmige Kontur auf. Die Strömungskanäle 11 und 21 sind immer abwechselnd, d.h. alternierend, in einer Ebenenrichtung nebeneinanderliegend angeordnet. In Strömungsrichtung vor dem Kontakt der Welle, d.h. vor der Aufteilung des zweiten Teilvolumens, bildet sich der Verteilerkanal 24 aus und nach dem Kontakt der Welle mit der Lage 43b, in Strömungsrichtung betrachtet, bildet sich der Rücklaufsammelkanal 28 aus. Besonders bevorzugt ist es, dass auch die sich der Lage 43a nähernden Wellen mit diesem verbunden sind, einerseits zur Erhöhung der mechanischen Stabilität der Temperiervorrichtung und andererseits zur Ausbildung einer vollständigen fluidischen Abgrenzung der Strömungskanäle 11 untereinander quer zu deren Strömungsrichtung. Die wärmeleitende Kontaktierung der Wellen der inneren Lage 43c zu sowohl der Lage 43b als auch 43a ist zudem besonders bevorzugt zur Gegenstromtemperierung von einer ersten Objektanordnung wärmeleitend verbunden mit der Lage 43b und einer zweiten Objektanordnung wärmeleitend verbunden mit der Lage 43a.

Die Gegenstromtemperierung über die Lage 43b und/oder die Lage 43a einer oder mehrerer Objektanordnungen erfolgt während des Durchströmens der Gegenstromtemperierungsvorrichtung 100 ausgehend von wenigstens einem ersten Temperiermitteleinlass 12 mit einem ersten Temperiermittel und ausgehend von wenigstens einem zweiten Temperiermitteleinlass 22 mit einem zweiten Temperiermittel, wobei das erste Temperiermittel in den wenigstens einen ersten Verteilerkanal 14 strömt und von dort aus auf die wenigstens zwei ersten Strömungskanäle 11 aufgeteilt wird, diese durchströmt und das erste Temperiermittel nach dem Durchströmen der ersten Strömungskanäle 11 wieder über den wenigstens einen ersten Rücklaufsammelkanal 18 gesammelt wird und der wenigstens eine ersten Rücklaufsammelkanal 18 schließlich das erste Temperiermittel zum Temperiermittelauslass 16, der mit dem Temperierkreislauf der Anwendung verbunden ist, weiterleitet.

Bei der Durchströmung der ersten Strömungskanäle 11 zur Temperierung einer ersten Objektanordnung, die wärmeleitend mit der Lage 43b verbunden ist, fließt die Wärmeenergie im Fall einer Kühlung, von der ersten Objektanordnung ausgehend, vorzugsweise im Wesentlichen im Bereich der wenigstens einen Haupttemperierfläche 42 durch die Wandstärke der Lage 43b in die Wandstärke der Lage 43c und der Lage 43c und gibt die Wärmeenergie schließlich an das erste Temperiermittel in die ersten Strömungskanäle 11 ab. Wie vorangehend beschrieben, sind die ersten Strömungskanäle 11 in einer Ebenenrichtung alternierend neben den zweiten Strömungskanälen 21 angeordnet.

Die zweiten Strömungskanäle 21 werden vom zweiten Temperiermittel in entgegengesetzter Richtung zu den ersten Strömungskanälen 11 durchströmt. Bei der Durchströmung der ersten Strömungskanäle 21 zur Temperierung einer ersten Objektanordnung, die wärmeleitend mit der Lage 43b verbunden ist, fließt die Wärmeenergie im Fall einer Kühlung, von der ersten Objektanordnung ausgehend, durch die Wandstärke der Lage 43b und dieses gibt die Wärmeenergie an das zweite Temperiermittel in den zweiten Strömungskanälen 21 ab. Die Wärmeenergie muss auf dem Weg von der ersten Objektanordnung auf der Seite der Lage 43b bis zum zweiten Temperiermittel nicht durch die Wandstärke der Lage 43c fließen, da die Amplitudenbereiche der Wellen der Lage 43c, die die Strömungskanäle 21 begrenzen, an der Lage 43a, vorzugsweise an deren Haupttemperierflächen (42), anliegen und nicht an der Lage 43b.

Bei der Temperierung wenigstens einer zweiten Objektanordnung in wärmeleitender Verbindung zur Lage 43a verhält es sich entsprechend umgekehrt. Hier muss die Wärmeenergie ausgehend von der zweiten Objektanordnung zum zweiten Temperiermittel in den Strömungskanälen 21 durch die Wandstärke der Lage 43a und die Wandstärke der Lage 43c fließen, wohingegen die Wärmeenergie zum ersten Temperiermittel in den Strömungskanälen 11 nur die Wandstärke der Lage 43a durchtreten muss.

In besonders bevorzugter, nicht dargestellter, Ausführung weist die innere Lage 43c innerhalb der Kontaktfläche zu der Lage 43a und oder 43b Durchgänge auf, über die das Temperiermittel direkt jeweils in Kontakt mit den Innenflächen der Lage 43a bzw. 43b steht, und die Wärmeenergie von und zu dem Temperiermittel nur die Lage 43a bzw. 43b der Gegenstromtemperiervorrichtung durchdringen muss. In weiterer besonders bevorzugter, nicht dargestellter, Ausführung weist die Lage 43c im Bereich der Strömungskanäle 11 und 21 lediglich Trennstege auf, die die Strömungskanäle 11, 21 voneinander trennen.

Die Lage 43c ist vorzugsweise insbesondere in den wärmeleitenden Kontaktbereichen zu der Lage 43b bzw. 43a aus einem wärmeleitfähigen metallischen und/oder polymeren Werkstoff hergestellt und/oder aus einem dünnen Material mit einer Wandstärke von weniger als 3 mm, besonders bevorzugt aus einem Material von weniger als 0,5 mm Wandstärke.

In der dargestellten Ausführungsform sind die ersten und zweiten Strömungskanäle 11, 21 in einer gemeinsamen Anordnungsebene angeordnet und die unmittelbar benachbarten ersten und zweiten Strömungskanäle 11, 21 unmittelbar aneinander angrenzend ausgebildet, wobei wenigstens eine oder zwei sich gegenüberliegende wärmeleitende Temperierflächen 42 für die Anlage an mindestens ein zu temperierendes Objekt 3 ausgebildet werden.

Die beispielhafte Ausführungsform der Vorrichtung gemäß den Figuren 3A-3C ist besonders vorteilhaft, da diese Ausführungsform der Gegenstromtemperierungsvorrichtung 100 im Wesentlichen nur durch drei Metallformblechteile oder drei Folien oder dünnwandige polymere Bauteile oder einem dreiteiligem Mischverbau der genannten Teile bzw. Werkstoffe gebildet ist, wobei die die Temperierflächen 42 durch zwei äußere untere und obere identische Schalen 43a und 43b und eine mittlere dreidimensional wellenförmig ausgebildete mittlere blech- oder folienartige Lage 43c gebildet wird. Es kann auch vorgesehen werden eine abweichende Anzahl von Metallformblechteilen oder Folien erfindungsgemäß zur Bildung der Vorrichtung vorzusehen.

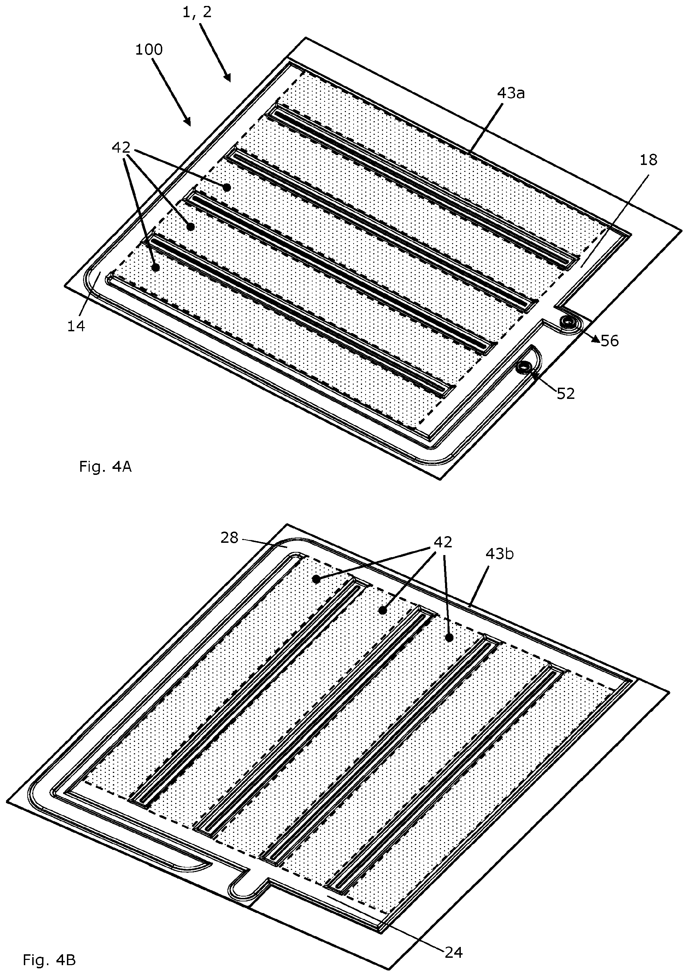

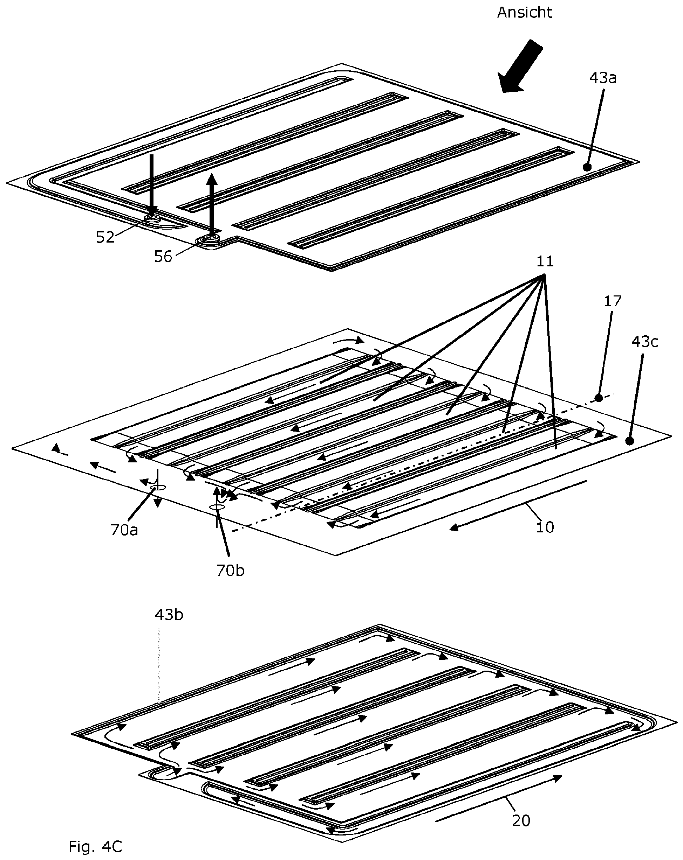

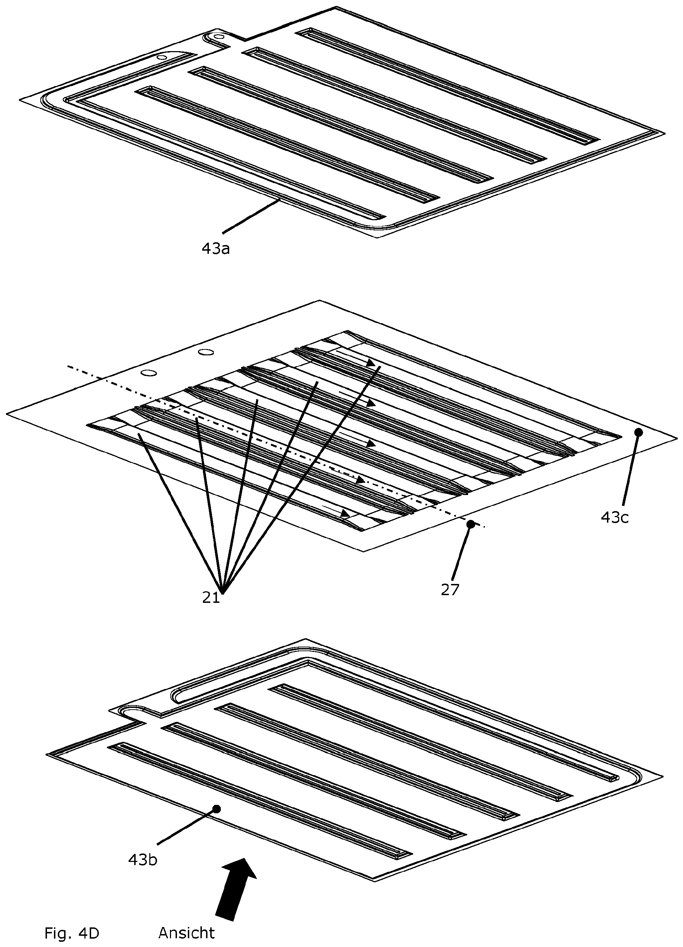

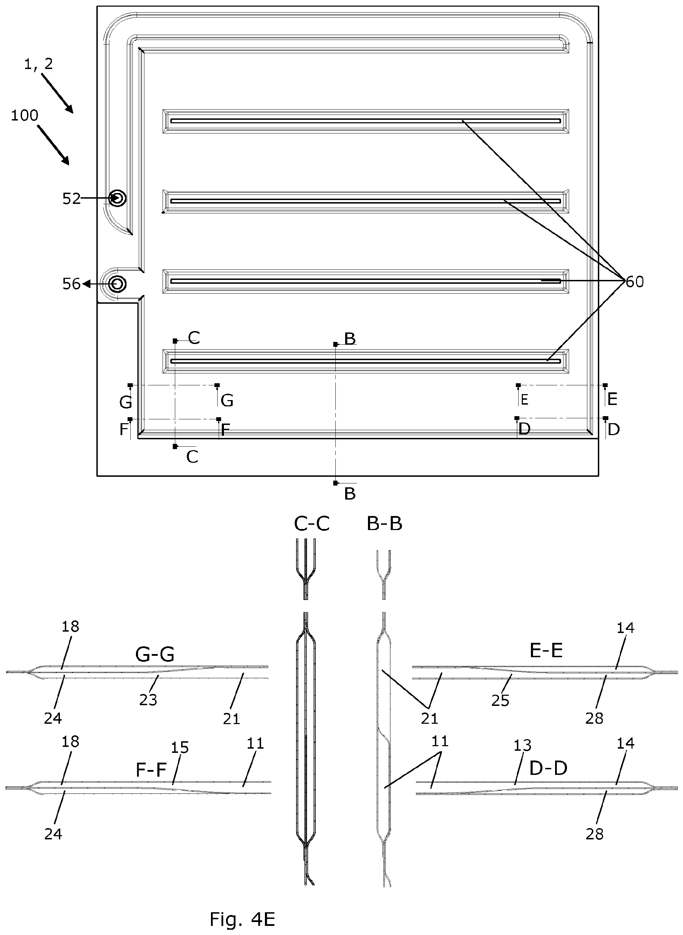

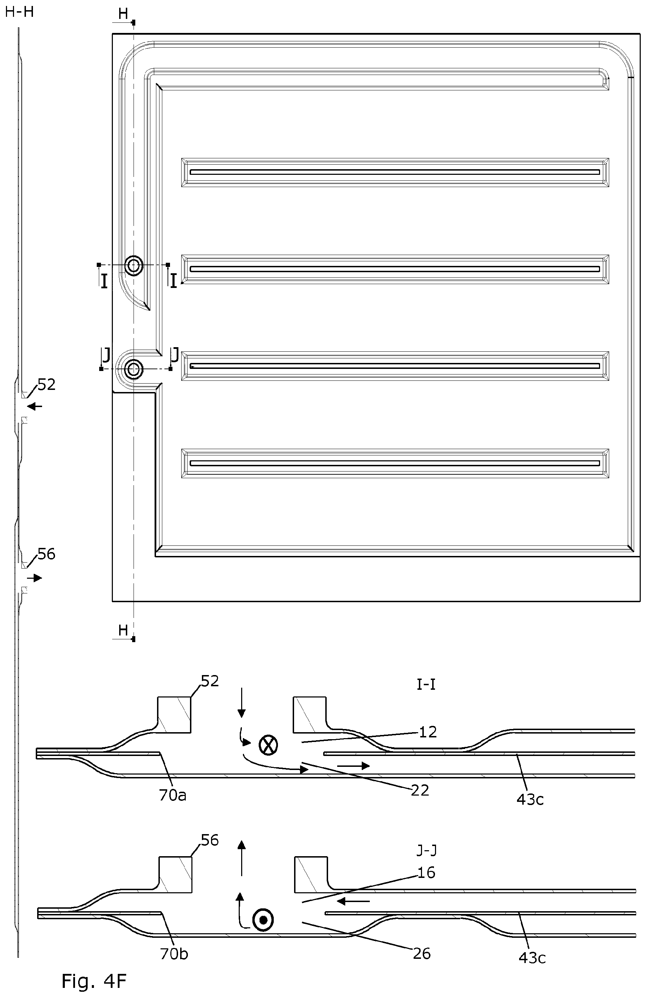

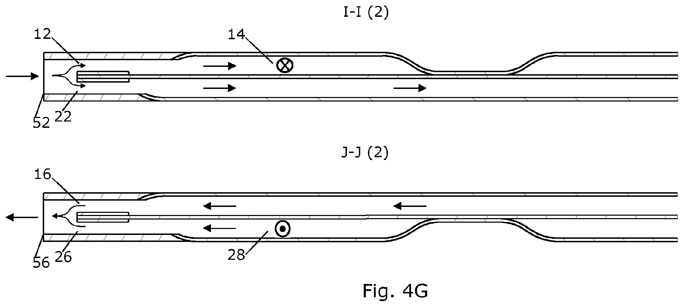

Wie auch bei der Ausführungsform nach Figuren 3 sind in der beispielhaften Ausführungsform gemäß Figuren 4 alle dargestellten Einzelteile der Gegenstromtemperierungsvorrichtung 100 baulich integrativ zu einer Einheit zusammengefasst, d.h., dass der erste Temperierabschnitt 1, der unter anderem die ersten Strömungskanäle 11 umfasst, und der zweite Temperierabschnitt 2, der unter anderem die zweiten Strömungskanäle 21 umfasst, in einer Baugruppe zusammengefasst sind. Mit der Ausführungsform nach den Figuren 4 lassen sich die gleichen Anordnungskonfigurationen B und C (siehe Fig. 4H, 4I, 4J) realisieren wie mit der Ausführungsform gemäß den Figuren 3.

Im Unterschied zur Ausführungsform der Figuren 3 sind der mindestens eine erste Temperiermitteleinlass 12 des ersten Temperierabschnitts 1 und der zweite Temperiermitteleinlass 22 des zweiten Temperierabschnitts 2 mit einem gemeinsamen Zulauf 52 des Temperierkreislaufs verbunden; und
wobei der mindestens eine erste Temperiermittelauslass 16 des ersten Temperierabschnitts 1 und der zweite Temperiermittelauslass 26 des zweiten Temperierabschnitts 2 mit einem gemeinsamen Rücklauf 56 des Temperierkreislaufs verbunden sind.

Daraus folgt, dass im Unterschied zur Ausführungsform nach den Figuren 3 die Ausführungsform gemäß Figuren 4 als äußere Temperiermittel-Schnittstellen nur besonders bevorzugt einen Zulauf 52 und einen Rücklauf 56 aufweist. Der Integrationsaufwand zur Einbindung der Ausführungsform nach Figuren 4 in nur einen Temperierkreislauf mit nur einer jeweils einer verfügbaren Schnittstelle zu einem Zulauf 52 und einem Rücklauf 56 der Anwendung ist gegenüber der Ausführungsform nach Figuren 3 dadurch deutlich reduziert.

Fig. 4A zeigt die perspektivische Ansicht auf die Seite der Lage 43a, des Zulaufs 52 und des Rücklaufs 56, wobei der Zulauf 52 und der Rücklauf 56 in nicht dargestellter Weise auch auf unterschiedlichen Seiten liegen können oder auch parallel zur Ebene des Gegenstromtemperierungsvorrichtung 100 liegen können.

Fig. 4B zeigt die perspektivische Ansicht auf die Seite der Lage 43b.

Fig. 4C zeigt eine perspektivische Explosionsdarstellung auf die Seite der Lagen 43a, 43c und 43b, auf der beispielhaft der Zulauf 52 und der Rücklauf 56 liegen. Die innere Lage 43c unterteilt das Gesamtvolumen in ein erstes Teilvolumen zwischen der Lage 43a und der inneren Lage 43c und in ein zweites Teilvolumen zwischen der Lage 43b und 43c, wobei das erste Teilvolumen sinngemäß den ersten Temperierabschnitt 1 und das zweite Teilvolumen den zweiten Temperierabschnitt 2 umfasst, wobei der erste und zweite Temperierabschnitt 1, 2 im Gegensatz zur Ausführungsform nach Figuren 1 oder 2 baulich in den Figuren 4 eine integrative Einheit bilden. In Fig. 4C sind die ersten Strömungskanäle 11 erkennbar, die von dem ersten Verteilerkanal 14 gespeist werden und nach dem Durchströmen in den Rücklaufsammelkanal 18 münden, welcher das erste Temperiermittel wieder sammelt und zum Rücklauf 56 der Gegenstromtemperiervorrichtung 100 leitet. Die Strömungsrichtungen des Temperiermittels sind in den Teilabbildungen der Fig. 4C mittels Pfeilen verdeutlicht.

Fig. 4D zeigt eine perspektivische Explosionsdarstellung auf die Seite der Lagen 43a, 43c und 43b, die der Seite mit dem Zulauf 52 und dem Rücklauf 56 in dieser beispielhaften Ausführungsform nach Figuren 4 gegenüberliegt. In der Ansichtsrichtung der Fig. 4D sind an der inneren Lage 43c die zweiten Strömungskanäle 21 erkennbar, die zwischen der inneren Lage 43c und der Lage 43b liegen bzw. von diesen gebildet werden. Die Strömungskanäle 21 werden von dem zweiten Verteilerkanal 24 gespeist und nach dem Durchströmen der Strömungskanäle 21 strömt das zweite Temperiermittel in den zweiten Rücklaufsammelkanal 28, welcher das zweite Temperiermittel wieder sammelt und zum Rücklauf 56 der Gegenstromtemperierungsvorrichtung 100 leitet. Diese Strömungswege innerhalb der Gegenstromtemperierungsvorrichtung 100 lassen sich den Figuren 4A bis 4E einschließlich der Schnittdarstellungen in Figur 4E entnehmen.

Ein weiterer Unterschied zur Ausführungsform nach Figuren 3 besteht darin, dass die Ausführungsform nach Figuren 4 über die sich erstreckende Fläche Durchbrüche 60 aufweisen kann, wie in Fig. 4E dargestellt. Diese Durchbrüche 60 ermöglichen einerseits eine einseitige direkte Befestigung der Gegenstromtemperierungsvorrichtung 100 an nicht dargestellten Teilen der Temperieranwendung und/oder der zu temperierenden Objektanordnung selbst über z.B. eine Verrastung oder eine Verschraubung oder eine Verschweißung der Randbereiche der Durchbrüche 60.

Andererseits bieten die Durchbrüche 60 auch das beidseitige in Form halten bzw. definierte Anpressen der Gegenstromtemperierungsvorrichtung 100 an die zu temperierende Fläche der wenigstens einen Objektanordnung, indem Verbindungselemente innerhalb der Fläche der Gegenstromtemperierungsvorrichtung 100 eingesetzt werden können, die eine direkte oder indirekte Verbindung herstellen zwischen der wenigstens einen zu temperierenden Fläche der wenigstens einen Objektanordnung und wenigstens einer weiteren gegenüberliegenden Fläche der Anwendung, beispielsweise eines Gehäuses oder einer zweiten Objektanordnung. Die Gegenstromtemperierungsvorrichtung 100 ist folglich bei diesem beispielhaften Einbauzustand zwischen der zu temperierenden Fläche auf der einen Seite und durch eine weitere Fläche auf der gegenüberliegenden Seite der Gegenstromtemperierung gehalten, wobei die sich gegenüberliegenden Flächen über Verbindungen durch die Durchbrüche 60 hindurch verbunden sind.

Über die beiden beispielhaft beschriebenen möglichen Einbauzustände lässt sich jeweils bewirken, dass der wärmeleitende Kontakt zu der wenigstens einen zu temperierenden Objektanordnung über die gesamte zu tempierende Fläche 42 auch bei größeren Gegenstromtemperierungsvorrichtungen 100 gewährleistet wird. Bei einer Verwendung eines dünnwandigen und/oder flexiblen Werkstoffs, z.B. eines dünnen Metallblechs oder einer Folie, zumindest im Bereich der Strömungskanäle lässt sich zudem über den hydrostatischen Druck des Temperiermittels ein zusätzliches Anpressen der Lage 43a und/oder 43b an die wenigstens eine zu temperierende Fläche realisieren.

Fig. 4F zeigt die Schnitte H-H, I-I und J-J durch den Zulauf 52 und den Rücklauf 56. Beispielhaft liegen in dieser Ausführungsform der erste Temperiermitteleinlass 12 des ersten Temperierabschnitts 1 und auch der zweite Temperiermitteleinlass 22 des zweiten Temperierabschnitts 2 im Bereich des Zulaufs (52). Einer der beiden oder beide Temperiermitteleinlässe 12, 22 können auch in nicht dargestellter Ausführung beabstandet zum Zulauf 52 angeordnet sein. In den Ansichten der Fig. 4F sind die Strömungsverläufe wiederum mittels Pfeilen angedeutet, wobei mittels des Symbols ⊗ angedeutet wird, dass ein Strömungsverlauf in die Bildebene hinein vorliegt, mit dem Symbol ⊙ wird verdeutlicht, das eine Strömung aus der Bildebene heraus erfolgt.

Nach dem Einströmen des Temperiermittels in den Zulauf 52 teilt sich in dieser beispielhaften Ausführung das Temperiermittel über den ersten Temperiermitteleinlass 12 auf den ersten Temperierabschnitt 1 in ein erstes Temperiermittel und über den zweiten Temperiermitteleinlass 22 auf den zweiten Temperierabschnitt 2 in ein zweites Temperiermittel auf, wobei der erste Temperiermitteleinlass 12 und der zweite Temperiermitteleinlass 22 mit dem Zulauf 52 derart fluidisch verbunden sind, dass die beiden Temperierabschnitte 1, 2 zueinander fluidisch parallelgeschaltet sind.

Da sich der erste Temperierabschnitt 1 und der zweite Temperierabschnitt 2 auf unterschiedlichen Seiten der inneren Lage 43c befinden, sich aber der vorzugsweise nur eine Zulauf 52 in dieser Ausführungsform nur auf einer Seite der Gegenstromtemperierungsvorrichtung 100 befindet, ist eine Durchflussöffnung 70a in die innere Lage 43c als Temperiermitteleinlass 22 zum zweiten, dem Zulauf 52 abgewandten, Temperierabschnitt 2 eingebracht.

Schnitt J-J der Fig. 4F zeigt, wie das erste und zweite Temperiermittel aus den beiden Temperierabschnitten 1, 2, von den Rücklaufsammelkanälen 18, 28 her kommend, über den ersten und zweiten Temperiermittelauslass 16, 26 wieder vor dem Rücklauf 56 zusammengeführt werden, wobei der zweite Temperiermittelauslass 26 durch die Durchflussöffnung 70b realisiert ist und der erste Temperiermittelauslass 16 der Öffnung des Rücklaufs 56 entspricht, durch welche das erste und zweite Temperiermittel nach deren Zusammenfluss abgeführt werden.

Fig. 4G zeigt weitere Schnitt- und Detailansichten der Gegenstromtemperierungsvorrichtung 100 gemäß Fig. 4A bzw. 4B, jedoch mit einer Variante der Zulauf- und Rücklauf-Schnittstellen-Anbindung. Bei dieser Variante der Zulauf- und Rücklauf-Schnittstellen-Anbindung sind der Zulauf 52 und der Rücklauf 56 am Rand der Gegenstromtemperierungsvorrichtung 100 über die Lagen 43a und 43b angebunden oder der Zulauf 52 und der Rücklauf 56 wird aus den Lagen 43a und 43b selbst gebildet. Die Ausführungsform nach Fign. 4 bietet somit den Vorteil, je nach den baulichen Gegebenheiten der Anwendung, den wenigstens einen Zulauf 52 und den wenigstens einen Rücklauf 56 an unterschiedlichen Positionen anzuordnen und in unterschiedliche Richtungen zeigen zu lassen.

Fig. 4H zeigt den Schnitt B-B der Fig. 4E in einer beispielhaften Anordnungskonfiguration mit einer zu temperierenden Objektanordnung 3b und einen Teilausschnitt einer weiteren Objektanordnung 3b. Besonders bevorzugt ist, dass jede Objektanordnung 3b jeweils mit wenigstens einem ersten und einem zweiten Strömungskanal 11 und 21 wärmeleitend verbunden ist. Besteht eine Objektanordnung aus mehreren Objekten 3b, sind vorzugsweise alle Objekte 3b in wärmeeleitender Verbindung zu jeweils einem ersten und einem zweiten Strömungskanal 11 und 21 wärmeleitend verbunden. Hierzu ist es besonders bevorzugt, die gemeinsame Breite eines ersten und eines zweiten Strömungskanals 11, 21 so auszulegen, dass diese die Abmessung des zu temperierenden einzelnen Objekts 3b in Querrichtung zur Strömungsrichtung der Strömungskanäle 11, 21 möglichst nicht wesentlich überschreiten oder vorzugsweise die gemeinsamen paarweisen Breiten eines ersten und eines zweiten Strömungskanals 11, 21 nur einen Bruchteil der Abmessung des zu temperierenden einzelnen Objekts 3b in Querrichtung zur Strömungsrichtung der Strömungskanäle 11, 21 entspricht, so dass vorzugsweise mehrere Paarungen aus einem ersten und einem zweiten Strömungskanal 11 und 21 wärmeleitend jeweils mit den einzelnen Objekten verbunden werden können.

Fig. 4I zeigt den Schnitt B-B der Fig. 4E in einer beispielhaften erweiterten Anordnungskonfiguration, bei der gegenüber der Darstellung in Fig. 4H eine zweite Gegenstromtemperierungsvorrichtung 100 wärmeleitend auf der gegenüberliegenden Seite mit der bzw. den zu temperierenden Objektanordnungen verbunden ist. Hierdurch lässt sich eine gleichmäßigere Temperaturverteilung innerhalb des Volumens der Objektanordnung realisieren. Bei dieser Anordnung ist es für eine optimale Temperaturgleichverteilung besonders bevorzugt, die sich gegenüberliegenden Strömungskanäle 11, 21 der ersten und der zweiten Gegenstromtemperierungsvorrichtung 100, wie in der Fig. 4I durch die sich gegenüberliegenden unterschiedlichen Bezugszeichen 21 und 11 bzw. 11 und 21 dargestellt, in entgegengesetzter Richtung durchströmen zu lassen.

Fig. 4J zeigt den Schnitt B-B der Fig. 4E in einer beispielhaften erweiterten Anordnungskonfiguration, bei der gegenüber der Darstellung in Fig. 4H eine zweite Objektanordnung und ein Teilausschnitt einer weiteren zweiten Objektanordnung auf der gegenüberliegenden Seite der ersten Objektanordnungen mit der einen Gegenstromtemperierungsvorrichtung 100 verbunden sind. Bei dieser Anordnungskonfiguration lassen sich zwei Anordnungsebenen von zu temperierenden Objektanordnungen mit nur einer Gegenstromtemperierungsvorrichtung 100 gleichzeitig temperieren.

Das Funktionsprinzip der bevorzugten Ausführung nach Figuren 4 bzgl. der Temperierung der zu temperierenden wenigstens einen Objektanordnung entspricht der Ausführungsform nach Figuren 3 und ist dieser zu entnehmen.

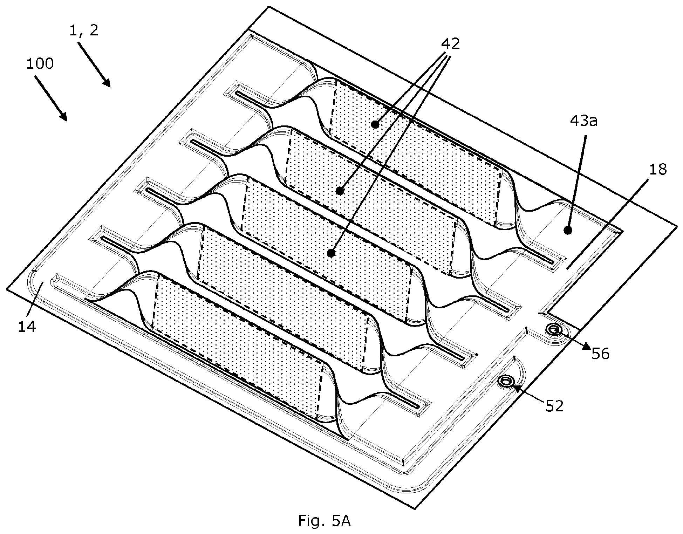

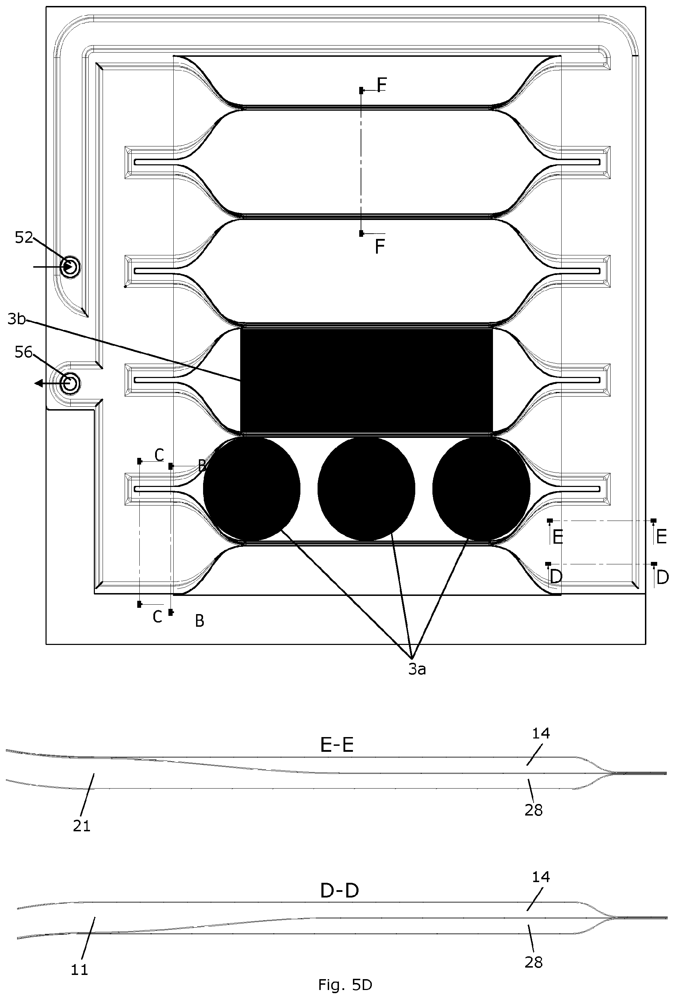

Die Figuren 5A bis 5E zeigen eine Ausführungsform, die vom Aufbau und der Funktion der Ausführungsform nach Figuren 4 entspricht, jedoch mit dem Unterschied, dass diese Ausführungsform für die vorangehend zu Figuren 1 beschriebene "Anordnungskonfiguration C" ausgelegt ist, bei der die Seitenflächen der zu temperierenden Objekte 3 temperiert werden. Um die Seitenflächen zu temperieren, sind beispielhaft jeweils ein erster und ein zweiter Strömungskanal 11, 21 paarweise jeweils an deren ersten Kanaleintritt 13 und zweiten Kanalaustritt 25 sowie zweiten Kanaleintritt 23 und ersten Kanalaustritt 15 um etwa 90° tordiert, so dass diese senkrecht zur Ebene der Gegenstromtemperierungsvorrichtung 100 verlaufen und damit Aufnahmeräume für zu temperierende Objekte bzw. Objektanordnungen 3, 3b schaffen, wie in Fig. 5D dargestellt.

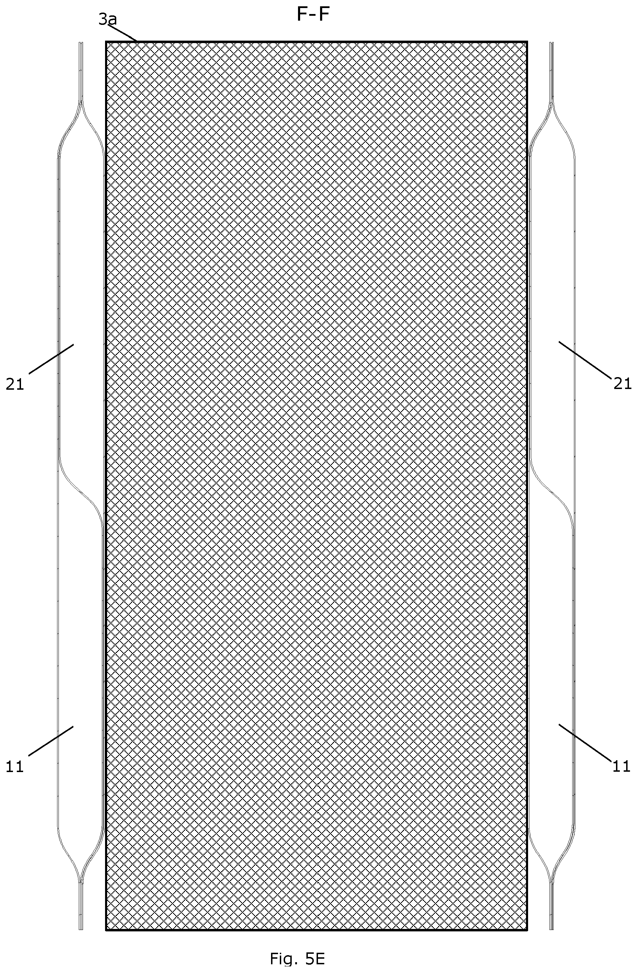

Fig. 5E zeigt den Schnitt F-F der Fig. 5D durch einen Aufnahmeraum mit einem zu temperierenden Objekt bzw. Objektanordnung 3, 3b. In diesem Schnitt wird das zu temperierende Objekt bzw. Objektanordnungen 3, 3b auf zwei sich gegenüberliegenden Seiten jeweils gegenstromtemperiert.

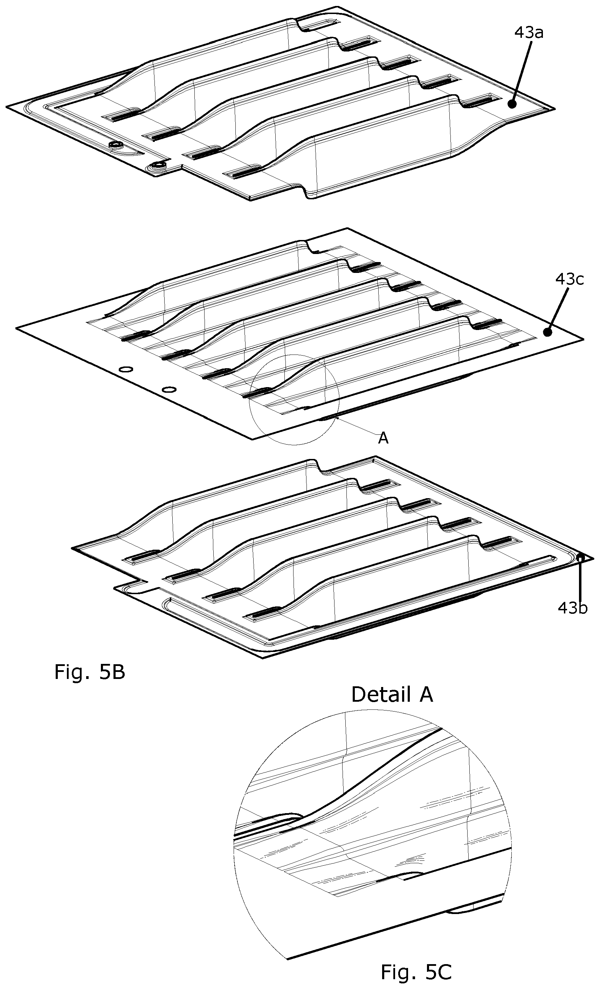

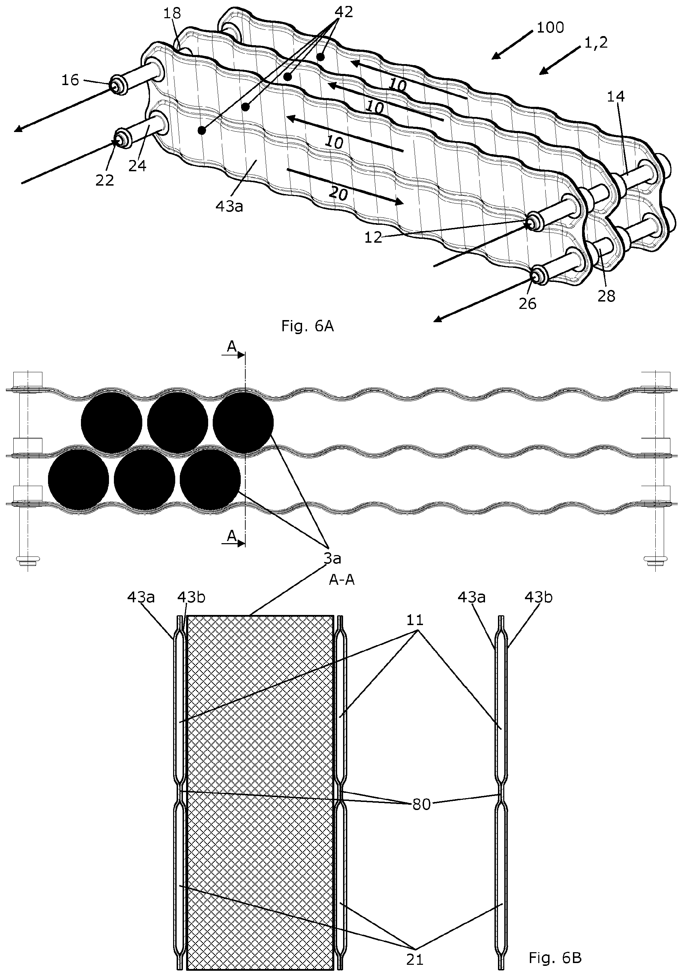

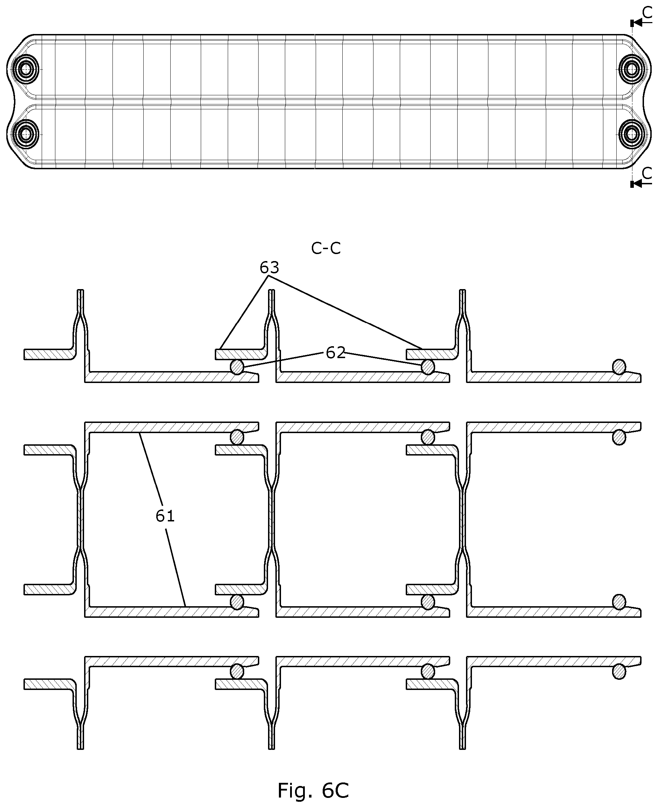

Die in den Figuren 6 dargestellte Ausführungsform der Gegenstromtemperierungsvorrichtung 100 ist wie die Ausführungsform nach Figuren 5 für die Anordnungskonfiguration C ausgelegt, jedoch mit dem Unterschied, dass diese aus mehreren modularen Einheiten zusammengesetzt werden kann, wobei zur Bildung der Gegenstromtemperierungsvorrichtung 100 wenigstens eine modulare Baugruppe erforderlich ist. Jede modulare Baugruppe umfasst jeweils einen ersten und einen zweiten Temperierabschnitt 1, 2. Die Temperierabschnitte 1, 2 wiederum umfassen jeweils wenigstens einen ersten und einen zweiten Strömungskanal 11, 21, mit denen fluidisch wenigstens ein erster und ein zweiter Verteilerkanal 14, 24 und wenigstens ein erster und ein zweiter Rücklaufsammelkanal 18, 28 verbunden sind. Die einzelnen Baugruppen können bei einer größeren zu temperierenden Objektanordnung, bestehend aus mehreren in Reihen angeordneten Objekten 3, über ihre ersten und zweiten Verteilerkanäle 14, 24 und ersten und zweiten Rücklaufsammelkanäle 18, 28 miteinander verbunden werden, wodurch sich entsprechend der Anzahl der verbundenen Baugruppen jeweils ein verlängerter gemeinsamer erster Verteilerkanal 14, ein verlängerter gemeinsamer zweiter Verteilerkanal 24, ein verlängerter gemeinsamer erster Rücklaufsammelkanal 18 und ein verlängerter gemeinsamer zweiter Rücklaufsammelkanal 28 ergibt.

Fig. 6C zeigt einen Schnitt durch den verlängerten gemeinsamen ersten Verteilerkanal 14 und durch den verlängerten gemeinsamen zweiten Rücklaufsammelkanal 28, der die Verbindungen der einzelnen Verteilerkanäle und Rücklaufsammelkanäle darstellt. Die Abdichtung der Verbindungen zwischen den Verteilerkanälen und Rücklaufsammelkanälen der miteinander verbundenen Baugruppen ist besonders bevorzugt über Dichtelemente 62, vorzugsweise in Form von Elastomerdichtungen oder Klebdichtungen oder einer Schweißabdichtung, realisiert. Besonders bevorzugt ist die Ausbildung einer Steckverbindung, bei der ein Verteilerkanal bzw. Rücklaufsammelkanal in oder auf eine Aufnahmeöffnung 63 einer weiteren Baugruppe gesteckt wird, welche fluidisch mit dem Verteilerkanal bzw. Rücklaufsammelkanal der weiteren Baugruppe verbunden ist.

Fig. 6B zeigt exemplarisch, wie die zu temperierenden, in Reihen angeordneten, Objekte von der Gegenstromtemperierungsvorrichtung 100 aufgenommen werden, indem diese innerhalb der Abstände der Strömungskanäle der einzelnen Baugruppen angeordnet sind und mit den Strömungskanälen 11, 21 wärmeleitend in Verbindung stehen.

Der Schnitt A-A der Fig. 6B zeigt den Querschnitt der Strömungskanäle 11, 21. In dieser besonders bevorzugten Ausführung sind die Strömungskanäle 11, 21 durch zwei mit einander am Rand fluidisch dicht verbundene Lagen 43a, 43b gebildet, die zusätzlich wenigstens einmal vorzugsweise etwa auf halber Höhe nochmals verbunden sind und diese wenigstens eine zusätzliche Verbindung 80 als im Wesentlichen linienförmige Verbindung 80 die fluidische Trennung zwischen dem ersten und zweiten Temperierabschnitt 1, 2 bildet. Durch weitere zusätzliche linienförmige Verbindungen 80 lassen sich auch mehr als zwei Temperierabschnitte 1, 2 realisieren.

D.h. der wenigstens eine erste und der wenigstens eine zweite Strömungskanal 11, 21 sind baulich in ein und derselben Baugruppe integriert.

In weiterer besonders bevorzugter, nicht dargestellter, Ausführung sind die Strömungskanäle 11, 21 je Baugruppe zumindest in Teilbereichen über den Querschnitt betrachtet einstückig über ein Strangpressverfahren oder ein Spritzgussverfahren oder ein Extrusionsverfahren hergestellt und bestehen aus einem metallischem und oder polymeren Folienwerkstoff oder einem metallischen und/oder polymeren Flachbahnmaterial oder dünnwandig geformten Material.

## Patentansprüche

1. Gegenstromtemperierungsvorrichtung (100) zur Temperierung mindestens eines Objektes, umfassend:
mindestens einen ersten Temperierabschnitt (1) mit mindestens einem ersten Strömungskanal (11) zur Durchströmung mit einem ersten Temperiermittel in einer ersten Strömungsrichtung (10) von einem ersten Kanaleintritt (13) zu einem ersten Kanalaustritt (15) entlang eines ersten Strömungsverlaufes (17); und
mindestens einen zweiten Temperierabschnitt (2) mit mindestens einem zweiten Strömungskanal (21) zur Durchströmung mit einem zweiten Temperiermittel in einer zweiten Strömungsrichtung (20) von einem zweiten Kanaleintritt (23) zu einem zweiten Kanalaustritt (25) entlang eines zweiten Strömungsverlaufes (27),
wobei die erste Strömungsrichtung (10) im Wesentlichen entgegengesetzt zu der zweiten Strömungsrichtung (20) verlaufend ausgebildet sind; und
wobei der mindestens eine erste und zweite Strömungskanal (11, 21) mit dem mindestens einen zu temperierenden Objekt (3, 3a, 3b) wärmeleitend in Verbindung steht,
**dadurch gekennzeichnet, dass** der mindestens eine erste und zweite Temperierabschnitt (1, 2) nur über einen Zulauf (52) und nur über einen Rücklauf (56) an einen Temperierkreislauf einer Anwendung angebunden sind;
wobei der mindestens eine erste Temperiermitteleinlass (12) des ersten Temperierabschnitts (1) und der zweite Temperiermitteleinlass (22) des zweiten Temperierabschnitts (2) mit einem gemeinsamen Zulauf (52) an den Temperierkreislauf der Anwendung angebunden sind; und
wobei der mindestens eine erste Temperiermittelauslass (16) des ersten Temperierabschnitts (1) und der zweite Temperiermittelauslass (26) des zweiten Temperierabschnitts (2) mit einem gemeinsamen Rücklauf (56) an den Temperierkreislauf der Anwendung angebunden sind.

2. Gegenstromtemperierungsvorrichtung (100) nach Anspruch 1, wobei die wärmeleitende Verbindung zwischen dem mindestens einen zu temperierenden Objekt sowohl zum mindestens einen ersten Strömungskanal (11) als auch mindestens einen zweiten Strömungskanal (21) entweder durch direkten Oberflächenkontakt des mindestens einen ersten Strömungskanals (11) und des mindestens einen zweiten Strömungskanals (21) an der Oberfläche des mindestens einen zu temperierenden Objekts (3, 3a, 3b) hergestellt ist,
und/oder
auf indirektem Weg über wärmeleitende Mittel zwischen der Oberfläche des mindestens einen zu temperierenden Objekts (3, 3a, 3b) und der bzw. den Oberflächen des mindestens einen ersten Strömungskanals (11) und dem mindestens einen zweiten Strömungskanal (21).

3. Gegenstromtemperierungsvorrichtung (100) nach Anspruch 2, wobei die wärmeleitenden Mittel mindestens eine wärmeleitfähige, spaltfüllende Masse und/oder mindestens eine wärmeleitfähige Schicht, vorzugsweise eine wärmeleitfähige Folie ist und/oder mindestens eine wärmeleitfähige Platte, vorzugsweise ein metallisches Blech oder wärmleitfähige Platte aus einem polymeren Werkstoff ist, und/oder die zu temperierenden Objekte (3, 3b), bei wenigstens zwei zu temperierenden Objekten (3, 3b) zumindest ein zu temperierendes Objekt (3, 3b) selbst als wärmeleitendes Mittel dient und die Wärmeleitung zwischen benachbarten Objekten und dem mindestens einen ersten Strömungskanal (11) und dem mindestens einen zweiten Strömungskanal (21) sicherstellt.

4. Gegenstromtemperierungsvorrichtung (100) nach einem der vorausgehenden Ansprüche, weiter umfassend mindestens einen ersten Temperiermitteleinlass (12) sowie mindestens einen ersten Verteilerkanal (14) zur Verbindung mindestens zweier erster Temperiermitteleintritte (13) mit dem mindestens einen ersten Temperiermitteleinlass (12); und/oder
weiter umfassend mindestens einen zweiten Temperiermitteleinlass (22) sowie mindestens einen zweiten Verteilerkanal (24) zur Verbindung mindestens zweier zweiter Temperiermitteleintritte (23) mit dem mindestens einen zweiten Temperiermitteleinlass (22).

5. Gegenstromtemperierungsvorrichtung (100) nach einem der vorausgehenden Ansprüche, weiter umfassend mindestens einen ersten Temperiermittelauslass (16) sowie mindestens einen ersten Rücklaufsammelkanal (18) zur Verbindung mindestens zweier erster Temperiermittelaustritte (15) mit dem mindestens einen ersten Temperiermittelauslass (16); und/oder
weiter umfassend mindestens einen zweiten Temperiermittelauslass (26) sowie mindestens einen zweiten Rücklaufsammelkanal (28) zur Verbindung mindestens zweier zweiter Temperiermittelaustritte (25) mit dem mindestens einen zweiten Temperiermittelauslass (26) der Vorrichtung.

6. Gegenstromtemperierungsvorrichtung (100) nach Anspruch 4 oder 5, wobei der mindestens eine erste Temperiermitteleinlass (12) und/oder der erste Verteilerkanal (14) dem mindestens einen ersten Temperiermittelauslass (15) und/oder dem ersten Rücklaufsammelkanal (18) in einer ersten Ebene parallel zu der ersten Strömungsrichtung (10) gegenüberliegend ausgebildet ist;
wobei der mindestens eine zweite Temperiermitteleinlass (22) und/oder der zweite Verteilerkanal (24) dem mindestens einem zweiten Temperiermittelauslass (26) und/oder dem zweiten Rücklaufsammelkanal (28) in der ersten Ebene gegenüberliegend ausgebildet ist; und
wobei der mindestens eine erste Temperiermitteleinlass (12) und/oder der erste Verteilerkanal (14) dem mindestens einen zweiten Temperiermittelauslass (26) und/oder dem mindestens einen zweiten Rücklaufsammelkanal (28) relativ zu der ersten Ebene gegenüberliegt und der mindestens eine zweite Temperiermitteleinlass (22) und/oder der mindestens eine zweite Verteilerkanal (24) dem mindestens einen ersten Temperiermittelauslass (16) bzw. ersten Rücklaufsammelkanal (18) relativ zu der ersten Ebene gegenüberliegt, wodurch das Temperiermittel in dem mindestens einen ersten Strömungskanal (11) in entgegengesetzter Richtung zu dem mindestens einen zweiten Strömungskanal ( 21) fließt.

7. Gegenstromtemperierungsvorrichtung (100) nach einem der vorausgehenden Ansprüche, mit einer Mehrzahl erster und zweiter Strömungskanäle (11, 21), wobei die ersten und zweiten Strömungskanäle (11, 21) entlang der zu temperierenden Objekte (3) im Wesentlichen geometrisch parallel zueinander angeordnet sind und die ersten und zweiten Strömungskanäle (11, 21) zudem in einer gemeinsamen Anordnungsebene orthogonal zu den Strömungsverläufen (17, 27) abwechselnd angeordnet sind.

8. Gegenstromtemperierungsvorrichtung (100) nach einem der vorausgehenden Ansprüche, mit einer Mehrzahl erster und zweiter Strömungskanäle (11, 21); wobei die ersten Strömungsverläufe (17) der ersten Strömungskanäle (11) im Wesentlichen parallel zueinander verlaufen und die ersten Strömungskanäle (11) in einer ersten Anordnungsebene angeordnet sind, wobei die zweiten Strömungsverläufe (27) der zweiten Strömungskanäle (21) im Wesentlichen parallel zueinander verlaufen und die zweiten Strömungskanäle ( 21) in einer zweiten Anordnungsebene angeordnet sind, und wobei die erste Anordnungsebene in orthogonaler Richtung zur zweiten Anordnungsebene beabstandet ist.

9. Gegenstromtemperierungsvorrichtung (100) nach Anspruch 7 oder 8, wobei zwischen den in der gemeinsamen Anordnungsebene oder in der jeweiligen ersten und zweiten Anordnungsebenen angeordneten jeweils benachbarten ersten und/oder zweiten Strömungskanälen (11, 21) ein Aufnahmeraum (4) zur Anordnung mindestens eines konduktiv zu temperierenden Objektes (3, 3a, 3b) ausgebildet ist, wobei ein erster Strömungskanal (11) und ein zweiter Strömungskanal ( 21) wärmeleitend mit dem mindestens einem zu temperierenden Objekt (3, 3a, 3b) in Verbindung steht.

10. Gegenstromtemperierungsvorrichtung (100) nach Anspruch 8 oder 9, wobei die in der gemeinsamen Anordnungsebene oder in der jeweiligen ersten und/oder zweiten Anordnungsebene angeordneten jeweils zumindest unmittelbar benachbarten ersten und zweiten Strömungskanäle (11, 21) aneinander angrenzend oder zumindest in geringerem Abstand als deren Strömungskanalbreite in gleicher Ebene und gleicher Richtung beabstandet ausgestaltet sind, zur Ausbildung mindestens einer gemeinsamen wärmeleitenden Haupttemperierfläche (42) für die Anlage an mindestens ein zu temperierendes Objekt (3, 3a, 3b).

11. Gegenstromtemperierungsvorrichtung (100) nach einem der vorausgehenden Ansprüche, wobei mindestens ein erster und/oder zweiter Strömungskanal (11, 21) in einer Ebene parallel zu dem Strömungsverlauf (17, 27) abgeflacht ausgestaltet ist, zur Ausbildung einer gemeinsamen wärmeleitenden Haupttemperierfläche (42) für mindestens ein konduktiv zu temperierendes Objekt (3, 3a, 3b).

12. Batteriegehäuse zur Aufnahme mindestens einer Batteriezelle, umfassend eine Gegenstromtemperierungsvorrichtung (100) nach einem der Ansprüche 1 bis 11.

13. Verwendung einer Gegenstromtemperierungsvorrichtung (100) nach einem der Ansprüche 1 bis 11 zur Temperierung von elektrischen Komponenten, wie beispielsweise elektrischer Energiespeicher und/oder elektrischer Schaltungen.

14. Verwendung nach Anspruch 13, zur Temperierung elektrischer Energiespeicher in Form von Rundzellen (3a), quaderförmiger prismatischer Zellen (3b) oder flacher taschenförmiger Batteriezellen, wobei zumindest ein erster und zweiter Strömungskanal (11, 21) an zumindest einem Teilbereich einer Außenwandung des zu temperierenden Energiespeichers anliegt oder zumindest wärmeleitend mit dem zu temperierenden Energiespeicher in Verbindung steht.

15. Verwendung nach Anspruch 13 oder 14, zur Temperierung von Energiespeichern einer stationären Anwendung oder eines Kraftfahrzeuges, eines Flugzeuges oder eines Schiffes.

## Claims

1. A counterflow temperature control device (100) for the temperature control of at least one object, comprising:
at least one first temperature control section (1) including at least one first flow channel (11) for a temperature control medium to flow through in a first flow direction (10) from a first channel inflow (13) to a first channel outflow (15) along a first flow path (17);
at least one second temperature control section (2) including at least one second flow channel (21) for a second temperature control medium to flow therethrough in a second flow direction (20) from a second channel inflow (23) to an opposite second channel outflow (25) along a second flow path (27),
wherein the first flow direction (10) is designed to extend substantially opposite to the second flow direction (20);
wherein the at least one first and second flow channel (11, 21) are in thermally conductive connection with the at least one object (3, 3a, 3b) to be temperature-controlled;
**characterized in that** the at least one first and second temperature control sections (1, 2) are connected to the temperature control circuit of the application only via one inlet (52) and only via one return (56);
wherein the at least one first temperature control medium inlet (12) of the first temperature control section (1) and the second temperature control medium inlet (22) of the second temperature control section (2) are connected to the temperature control circuit of the application by a common feed (52); and
wherein the at least one first temperature control medium inlet (16) of the first temperature control section (1) and the second temperature control medium inlet (26) of the second temperature control section (2) are connected to the temperature control circuit of the application by a common return (56).

2. The counterflow temperature control device (100) of claim 1, wherein the thermally-conductive connection between the at least one object to be temperature-controlled and the at least one first flow channel (11) as well as the at least one second flow channel (21) is made either by direct surface contact of the at least one first flow channel (11) and the at least one second flow channel (21) on the surface of the at least one object (3, 3a, 3b) to be temperature-controlled,
and/or
indirectly via a thermally conductive medium between the surface of the at least one object to be temperature-controlled (3, 3a, 3b) and the surface or surfaces of the at least one first flow channel (11) and the at least one second flow channel (21).

3. The counterflow temperature control device (100) of claim 2, wherein the thermally conductive media are at least one thermally conductive, gap-filling mass and/or at least one thermally conductive layer, preferably a thermally conductive film and/or at least one thermally conductive plate, preferably a metal sheet or a thermally conductive plate of a polymer material, and/or the objects (3, 3b) to be temperature-controlled, wherein in case of at least two objects (3, 3b) to be temperature-controlled, at least one object (3, 3b) to be temperature-controlled itself serves as a thermally conductive medium and ensures the thermal conduction between adjacent objects and the at least one first flow channel (11) and the at least one second flow channel (21).

4. The counterflow temperature control device (100) of one of the preceding claims, further comprising at least one first temperature control medium inlet (12) as well as at least one first distribution channel (14) for connecting at least two first temperature control medium inflows (13) to the at least one first temperature control medium inlet (12); and/or
further comprising at least one temperature control medium inlet (22) as well as at least one second distribution channel (24) for connecting at least two second temperature control medium inflows (23) to the at least one second temperature control medium inlet (22).

5. The counterflow temperature control device (100) of one of the preceding claims, further comprising at least one first temperature control medium outlet (16) as well as at least one first return flow collection channel (18) for connecting at least two first temperature control medium outflows (15) to the at least one first temperature control medium outlet (16); and/or
further comprising at least one second temperature control medium outlet (26) as well as at least one second return flow collection channel (28) for connecting at least two second temperature control medium outflows (25) to the at least one second temperature control medium inlet (26) of the device.

6. The counterflow temperature control device (100) of claim 4 or 5, wherein the at least one first temperature control medium inlet (12) and/or the first distribution channel (14) is formed opposite the at least one first temperature control medium outlet (15) and/or the first return flow collection channel (18) in a first plane parallel to the first flow direction (10);
wherein the at least one second temperature control medium inlet (22) and/or the second distribution channel (24) is formed opposite to the at least one second temperature control medium outlet (26) and/or the second return flow collecting channel (28) in the first plane; and
wherein the at least one first temperature control medium inlet (12) and/or the first distribution channel (14) is located opposite to the at least one second temperature control medium outlet (26) and/or the at least one second return flow collecting channel (28) relative to the first plane and the at least one second temperature control medium inlet (22) and/or the at least one second distribution channel (24) is located opposite to the at least one first temperature control medium outlet (16) or the first return flow collecting channel (18) relative to the first plane, whereby the temperature control medium in the at least one first flow channel (11) flows in the opposite direction to the at least one second flow channel (21).

7. The counterflow temperature control device (100) of one of the preceding claims, comprising a plurality of first and second flow channels (11, 21), the first and second flow channels (11, 21) being arranged along the objects (3) to be temperature-controlled substantially geometrically parallel to each other, and the first and second flow channels (11, 21) being still being arranged alternately in a common arrangement plane orthogonal to the flow paths (17, 27).

8. The counterflow temperature control device (100) of one of the preceding claims, comprising a plurality of first and second flow channels (11, 21); wherein the first flow paths (17) of the first flow channels (11) extend substantially parallel to each other and the first flow channels (11) are arranged in a first arrangement plane, wherein the second flow paths (27) of the second flow channels (21) extend substantially parallel to each other and the second flow channels (21) are arranged in a second arrangement plane, with the first arrangement plane being spaced from the second arrangement plane in the orthogonal direction.

9. The counterflow temperature control device (100) of claim 7 or 8, wherein a receiving space (4) for arranging at least one object (3, 3a, 3b) to be conductively temperature-controlled is formed between the respective adjacent first and second flow channels (11, 21) arranged in the common arrangement plane or the respective first and/or second arrangement plane, wherein a first flow channel (11) and a second flow channel (21) is in thermal conductive connection with at least one object (3, 3a, 3b) to be temperature-controlled.

10. The counterflow temperature control device (100) of claim 8 or 9, wherein the respective at least directly adjacent first and/or second flow channels (11, 21), which are arranged in the common arrangement plane or in the respective first and/or second arrangement plane, are designed adjacent to each other or at least at a distance, in the same plane and the same direction, smaller than their flow channel width in order to form a common main temperature control surface (42) for contact with at least one object (3, 3a, 3b) to be temperature-controlled.

11. The counterflow temperature control device (100) of one of the preceding claims, wherein at least one first and/or second flow channel (11, 21) is designed to be flattened in a plane parallel to the flow path (17, 27), for forming a common thermally conductive main temperature control surface (42) for at least one object (3, 3a, 3b) to be conductively temperature-controlled.

12. A battery housing for accommodating at least one battery cell, comprising a counterflow temperature control device (100) according to any one of claims 1 to 11.

13. A usage of a counterflow temperature control device (100) of any one of claims 1 to 11 for the temperature control of electrical components, such as electrical energy storages and/or electrical circuits.

14. The usage of claim 13, for the temperature control of electrical energy storages in the form of round cells (3a), cuboid prismatic cells (3b) or flat, pocket-shaped battery cells, wherein at least one first and one second flow channel (11, 21) is brought into abutment with at least a partial region of an outer wall of the energy storage to be temperature-controlled and/or is at least in thermally conductive connection with the energy storage to be temperature-controlled.

15. The usage of claim 13 or 14 for the temperature control of energy storages of a stationary application or a motor vehicle, an aircraft or a ship.

## Revendications

1. Dispositif de régulation de température à contre-courant (100) pour réguler la température d'au moins un objet, comprenant :
au moins une première portion de régulation de température (1) dotée d'au moins un premier canal d'écoulement (11) pour l'écoulement d'un premier fluide de régulation de température dans une première direction d'écoulement (10) allant d'une première entrée de canal (13) à une première sortie de canal (15) le long d'un premier trajet d'écoulement (17) ; et
au moins une deuxième portion de régulation de température (2) dotée d'au moins un deuxième canal d'écoulement (21) pour l'écoulement d'un deuxième fluide de régulation de température dans une deuxième direction d'écoulement (20) allant d'une deuxième entrée de canal (23) à une deuxième sortie de canal (25) le long d'un deuxième trajet d'écoulement (27),
dans lequel
la première direction d'écoulement (10) s'étend sensiblement en sens inverse de la deuxième direction d'écoulement (20) ; et
ledit au moins un premier et un deuxième canal d'écoulement (11, 21) est en liaison thermoconductrice avec ledit au moins un objet (3, 3a, 3b) à réguler en température,
**caractérisé en ce que**
lesdites au moins une première et deuxième portions de régulation de température (1, 2) sont reliées à un circuit de régulation de température d'une installation par une seule alimentation (52) et par un seul retour (56) ;
au moins une première admission de fluide de régulation de température (12) de la première portion de régulation de température (1) et une deuxième admission de fluide de régulation de température (22) de la deuxième portion de régulation de température (2) sont reliées au circuit de régulation de température de l'installation par une alimentation commune (52) ; et
au moins une première décharge de fluide de régulation de température (16) de la première portion de régulation de température (1) et une deuxième décharge de fluide de régulation de température (26) de la deuxième portion de régulation de température (2) sont reliées au circuit de régulation de température de l'installation par un retour commun (56).

2. Dispositif de régulation de température à contre-courant (100) selon la revendication 1,
dans lequel la liaison thermoconductrice dudit au moins un objet à réguler en température avec ledit au moins un premier canal d'écoulement (11) et avec ledit au moins un deuxième canal d'écoulement (21) est établie
par contact direct en surface dudit au moins un premier canal d'écoulement (11) et dudit au moins un deuxième canal d'écoulement (21) sur la surface dudit au moins un objet à réguler en température (3, 3a, 3b),
et/ou
indirectement par l'intermédiaire de moyens thermoconducteurs entre la surface dudit au moins un objet à réguler en température (3, 3a, 3b) et la ou les surfaces dudit au moins un premier canal d'écoulement (11) et dudit au moins un deuxième canal d'écoulement (21).

3. Dispositif de régulation de température à contre-courant (100) selon la revendication 2,
dans lequel les moyens thermoconducteurs sont au moins une masse thermoconductrice de remplissage d'interstice et/ou au moins une couche thermoconductrice, de préférence une feuille thermoconductrice, et/ou au moins une plaque thermoconductrice, de préférence une tôle métallique ou une plaque thermoconductrice en matériau polymère, et/ou les objets (3, 3b) à réguler en température, ou, dans le cas d'au moins deux objets (3, 3b) à réguler en température, au moins un objet (3, 3b) à réguler en température sert lui-même de moyen thermoconducteur et assure la conduction thermique entre les objets adjacents et ledit au moins un premier canal d'écoulement (11) et ledit au moins un deuxième canal d'écoulement (21).

4. Dispositif de régulation de température à contre-courant (100) selon l'une des revendications précédentes,
comprenant en outre au moins une première admission de fluide de régulation de température (12) et au moins un premier canal de distribution (14) pour relier au moins deux premières entrées de fluide de régulation de température (13) à ladite au moins une première admission de fluide de régulation de température (12) ; et/ou
comprenant en outre au moins une deuxième admission de fluide de régulation de température (22) et au moins un deuxième canal de distribution (24) pour relier au moins deux deuxièmes entrées de fluide de régulation de température (23) à ladite au moins une deuxième admission de fluide de régulation de température (22).

5. Dispositif de régulation de température à contre-courant (100) selon l'une des revendications précédentes,
comprenant en outre au moins une première décharge de fluide de régulation de température (16) et au moins un premier canal de collecte de retour (18) pour relier au moins deux premières sorties de fluide de régulation de température (15) à ladite au moins une première décharge de fluide de régulation de température (16) ; et/ou
comprenant en outre au moins une deuxième décharge de régulation de température (26) et au moins un deuxième canal de collecte de retour (28) pour relier au moins deux deuxièmes sorties de fluide régulation de température (25) à ladite au moins une deuxième décharge de fluide de régulation de température (26) du dispositif.

6. Dispositif de régulation de température à contre-courant (100) selon la revendication 4 ou 5,
dans lequel ladite au moins une première admission de fluide de régulation de température (12) et/ou le premier canal de distribution (14) est réalisé(e) à l'opposé de ladite au moins une première sortie de fluide de régulation de température (15) et/ou du premier canal de collecte de retour (18) dans un premier plan parallèle à la première direction d'écoulement (10) ;
ladite au moins une deuxième admission de fluide de régulation de température (22) et/ou le deuxième canal de distribution (24) est réalisé(e) à l'opposé de ladite au moins une décharge de fluide de régulation de température (26) et/ou du deuxième canal de collecte de retour (28) dans le premier plan ; et
ladite au moins une première admission de fluide de régulation de température (12) et/ou le canal de distribution (14) est situé(e) à l'opposé de ladite au moins une deuxième décharge de fluide de régulation de température (26) et/ou dudit au moins un deuxième canal de collecte de retour (28) par rapport au premier plan, et ladite au moins une deuxième admission de fluide de régulation de température (22) et/ou ledit au moins un deuxième canal de distribution (24) est situé(e) à l'opposé de ladite au moins une première décharge de fluide de régulation de température (16) ou dudit premier canal de collecte de retour (18) par rapport au premier plan, moyennant quoi le fluide de régulation de température dans ledit au moins un premier canal d'écoulement (11) s'écoule en sens inverse dudit au moins un deuxième canal d'écoulement (21).

7. Dispositif de régulation de température à contre-courant (100) selon l'une des revendications précédentes,
comprenant une pluralité de premiers et deuxièmes canaux d'écoulement (11, 21), les premiers et les deuxièmes canaux d'écoulement (11, 21) étant disposés, sur le plan géométrique, sensiblement parallèlement l'un à l'autre le long des objets (3) à réguler en température, et les premiers et les deuxièmes canaux d'écoulement (11, 21) étant en outre disposés en alternance dans un plan d'agencement commun orthogonal aux trajets d'écoulement (17, 27).

8. Dispositif de régulation de température à contre-courant (100) selon l'une des revendications précédentes,
comprenant une pluralité de premiers et de deuxièmes canaux d'écoulement (11, 21) ; les premiers trajets d'écoulement (17) des premiers canaux d'écoulement (11) étant sensiblement parallèles les uns aux autres et les premiers canaux d'écoulement (11) étant disposés dans un premier plan d'agencement, les deuxièmes trajets d'écoulement (27) des deuxièmes canaux d'écoulement (21) étant sensiblement parallèles les uns aux autres et les deuxièmes canaux d'écoulement (21) étant disposés dans un deuxième plan d'agencement, le premier plan d'agencement étant espacé du deuxième plan d'agencement dans la direction orthogonale.

9. Dispositif de régulation de température à contre-courant (100) selon la revendication 7 ou 8,
dans lequel un espace de réception (4) pour le placement d'au moins un objet (3, 3a, 3b) à réguler en température par conduction est formé entre les premiers et/ou deuxièmes canaux d'écoulement adjacents (11, 21) disposés dans le plan d'agencement commun ou dans les premier et deuxième plans d'agencement respectifs, un premier canal d'écoulement (11) et un deuxième canal d'écoulement (21) étant en liaison thermoconductrice avec ledit au moins un objet (3, 3a, 3b) à réguler en température.

10. Dispositif de régulation de température à contre-courant (100) selon la revendication 8 ou 9,
dans lequel les premiers et deuxièmes canaux d'écoulement (11, 21) respectifs, au moins immédiatement adjacents, disposés dans le plan d'agencement commun ou dans le premier et/ou le deuxième plan d'agencement respectif, sont conçus pour être adjacents l'un à l'autre ou espacés au moins d'une distance inférieure à la largeur de canal d'écoulement, dans le même plan et dans la même direction, afin de former au moins une surface principale de régulation de température thermoconductrice commune (42) destinée à venir en appui contre au moins un objet (3, 3a, 3b) à réguler en température.

11. Dispositif de régulation de température à contre-courant (100) selon l'une des revendications précédentes,
dans lequel au moins un premier et/ou un deuxième canal d'écoulement (11, 21) est conçu de manière aplati dans un plan parallèle au trajet d'écoulement (17, 27), afin de former une surface principale de régulation de température thermoconductrice commune (42) pour au moins un objet (3, 3a, 3b) à réguler en température par conduction.

12. Boîtier de batterie destiné à accueillir au moins une cellule de batterie, comprenant un dispositif de régulation de température à contre-courant (100) selon l'une des revendications 1 à 11.

13. Utilisation d'un dispositif de régulation de température à contre-courant (100) selon l'une des revendications 1 à 11 pour la régulation de la température de composants électriques, tels que des dispositifs de stockage d'énergie électrique et/ou des circuits électriques.

14. Utilisation selon la revendication 13 pour la régulation de la température de dispositifs de stockage d'énergie électrique sous forme de cellules rondes (3a), de cellules prismatiques parallélépipédiques (3b) ou de cellules de batterie plates en forme de poche,
dans laquelle au moins un premier et un deuxième canal d'écoulement (11, 21) sont en appui contre au moins une zone partielle d'une paroi extérieure du dispositif de stockage d'énergie à réguler en température ou sont en liaison thermoconductrice avec le dispositif de stockage d'énergie à réguler en température.

15. Utilisation selon la revendication 13 ou 14 pour la régulation de la température de dispositifs de stockage d'énergie dans une installation stationnaire ou dans un véhicule automobile, un avion ou un navire.
